# EUROPEAN PATENT APPLICATION

(11) **EP 4 641 825 A1**
(43) Date of publication of application: **29.10.2025**
(21) Application number: 23906469.4
(22) Date of filing: 27.10.2023
(51) Int. Cl.: H01P 1/18, H03H 7/20

(54) **DIGITAL PHASE SHIFT CIRCUIT AND DIGITAL PHASE SHIFTER**

(30) Priority: 20.12.2022 JP 2022203322
(71) Applicant: Fujikura Ltd., Tokyo 135-8512 (JP)
(72) Inventor: UEMICHI Yusuke, Sakura-shi, Chiba 285-8550 (JP)
(74) Representative: Lavoix
(86) International application number: PCT/JP2023/038899
(87) International publication number: WO 2024/135096

(57) **Abstract**

A digital phase shift circuit includes a signal line, a first line including a first parallel line extending parallel to the signal line, a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, and a second intersecting line extending toward the signal line in the intersection direction from a first end portion of the third parallel line, a first ground conductor, a second ground conductor, a first electronic switch, and a second electronic switch, in which the signal line is located between the first parallel line and the second parallel line.

## Description

### TECHNICAL FIELD

The present invention relates to a digital phase shift circuit and a digital phase shifter.

Priority is claimed on Japanese Patent Application No. 2022-203322 filed December 20, 2022, the content of which is incorporated herein by reference.

### BACKGROUND ART

For example, Non Patent Document 1 discloses a digital control type phase shift circuit (digital phase shift circuit) for microwaves, quasi-millimeter waves, or millimeter waves. As shown in FIG. 2 of Non Patent Document 1, the digital phase shift circuit includes a signal line, a pair of inner lines, a pair of outer lines, a first ground bar, a second ground bar, a pair of N-type metal-oxide-semiconductor switches (NMOS switches), and the like. The pair of inner lines are provided on both sides of the signal line. The pair of outer lines are provided outside the pair of inner lines. The first ground bar is connected to one end of each inner line and one end of each outer line. The second ground bar is connected to the other end of each outer line. Each NMOS switch is provided between the other end of each inner line and the second ground bar.

In such a digital phase shift circuit, whether a return current generated due to the transmission of a signal wave in the signal line flows through the pair of inner lines or the pair of outer lines is switched depending on whether the pair of NMOS switches are opened or closed. Accordingly, an operation mode of the digital phase shift circuit is switched between a low-latency mode and a high-latency mode. That is, in the digital phase shift circuit, the operation mode is the low-latency mode in a case in which the return current flows through the pair of inner lines, and the operation mode is the high-latency mode in a case in which the return current flows through the pair of outer lines.

### Citation List

### Non Patent Document

Non Patent Document 1: A Ka-band Digitally-Controlled Phase Shifter with sub-degree Phase Precision (2016, IEEE, RFIC)

### SUMMARY OF INVENTION

### Technical Problem

In the digital phase shift circuit as described above, it is desirable for the inductance, which is one of the circuit constants, to have a value (inductance value) in the high-latency mode that is sufficiently greater than an inductance value in the low-latency mode. However, in a case in which the above-described structure of the related art is applied to the digital phase shift circuit, there is a problem in that a size of the circuit increases in a case in which the inductance value is to be increased. As a result, in the digital phase shift circuit in the related art, it is difficult to achieve both size reduction and sufficient securing of a difference (phase shift amount) between a phase in the low-latency mode and a phase in the high-latency mode.

The present invention has been made in view of the above-described circumstances, and an object of the present invention is to provide a digital phase shift circuit and a digital phase shifter capable of achieving both size reduction and expansion of a difference between a phase in a low-latency mode and a phase in a high-latency mode.

### Solution to Problem

An aspect 1 of the present invention relates to a digital phase shift circuit including: a signal line; a first line including a first parallel line extending parallel to the signal line; a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, and a second intersecting line extending toward the signal line in the intersection direction from a first end portion of the third parallel line; a first ground conductor electrically connected to a first end portion of the first parallel line and the first end portion of the second parallel line; a second ground conductor connected to a first end portion of the second line; a first electronic switch provided between a second end portion of the first parallel line and the second ground conductor; and a second electronic switch provided between a second end portion of the second parallel line and the second ground conductor, in which the signal line is located between the first parallel line and the second parallel line.

According to the aspect 1 of the present invention, the first intersecting line, the third parallel line, and the second intersecting line constitute a loop line that is looped in a U-shape. Therefore, a magnetic field generated by a return current in the first intersecting line, a magnetic field generated by a return current in the third parallel line, and a magnetic field generated by a return current in the second intersecting line are strengthened at the center of the loop. As a result, it is possible to increase an inductance value in a high-latency mode without excessively increasing a size of the digital phase shift circuit, and it is possible to sufficiently increase a difference (phase shift amount) between a phase in a low-latency mode and a phase in the high-latency mode.

In addition, an aspect 2 of the present invention relates to the digital phase shift circuit according to the aspect 1, further including: a connection pad provided between the second end portion of the second parallel line and the second electronic switch, in which a maximum value of a dimension of the connection pad in the intersection direction is greater than a width of the second parallel line.

In addition, an aspect 3 of the present invention relates to the digital phase shift circuit according to the aspect 2, in which at least a part of the second intersecting line and at least a part of the connection pad face each other in the longitudinal direction.

In addition, an aspect 4 of the present invention relates to the digital phase shift circuit according to any one of the aspects 1 to 3, in which, in the intersection direction, a distance between a center line of the second parallel line and a center line of the third parallel line is greater than a distance between the center line of the second parallel line and an outer edge of the first ground conductor on a side of the third parallel line.

In addition, an aspect 5 of the present invention relates to the digital phase shift circuit according to any one of the aspects 1 to 4, in which at least one of the first ground conductor or the second ground conductor has a multilayer structure.

In addition, an aspect 6 of the present invention relates to the digital phase shift circuit according to any one of the aspects 1 to 5, in which the second intersecting line extends to intersect the second parallel line, the signal line, and the first parallel line in a plan view, and the second line further includes a fourth parallel line extending parallel to the signal line from a first end portion of the second intersecting line, and a third intersecting line extending toward the signal line in the intersection direction from a first end portion of the fourth parallel line.

In addition, an aspect 7 of the present invention relates to the digital phase shift circuit according to any one of the aspects 1 to 6, in which the first line further includes a fourth intersecting line extending away from the signal line in the intersection direction from the first end portion of the first parallel line, a fifth parallel line extending parallel to the signal line from a first end portion of the fourth intersecting line, and a fifth intersecting line extending toward the signal line in the intersection direction from a first end portion of the fifth parallel line.

In addition, an aspect 8 of the present invention relates to a digital phase shifter including: a plurality of the digital phase shift circuits according to any one of the aspects 1 to 6; and a plurality of inverted digital phase shift circuits in which the digital phase shift circuits are inverted with respect to a center line of the signal line, in which the plurality of digital phase shift circuits and the plurality of inverted digital phase shift circuits are alternately cascade-connected in the longitudinal direction.

In addition, an aspect 9 of the present invention relates to the digital phase shifter according to the aspect 8, in which the digital phase shift circuit and the inverted digital phase shift circuit that are adjacent to each other in the longitudinal direction are cascade-connected such that the digital phase shift circuit and the inverted digital phase shift circuit partially enter each other.

In addition, an aspect 10 of the present invention relates to a digital phase shifter including: a first row including a plurality of the digital phase shift circuits according to any one of the aspects 1 to 6 and a plurality of inverted digital phase shift circuits in which the digital phase shift circuits are inverted with respect to a center line of the signal line; a second row including a plurality of the digital phase shift circuits according to any one of the aspects 1 to 6 and a plurality of inverted digital phase shift circuits in which the digital phase shift circuits are inverted with respect to a center line of the signal line, and extending parallel to the first row to overlap the first row when viewed in the intersection direction; and a connection portion configured to electrically connect a first end portion of the first row and a first end portion of the second row, in which the plurality of digital phase shift circuits and the plurality of inverted digital phase shift circuits included in the first row are alternately cascade-connected in the longitudinal direction, the plurality of digital phase shift circuits and the plurality of inverted digital phase shift circuits included in the second row are alternately cascade-connected in the longitudinal direction, and the third parallel line included in the first row and the third parallel line included in the second row are not adjacent to each other in the intersection direction.

In addition, an aspect 11 of the present invention relates to the digital phase shifter according to the aspect 10, in which the digital phase shift circuit and the inverted digital phase shift circuit that are adjacent to each other in the longitudinal direction in the first row are cascade-connected such that the digital phase shift circuit and the inverted digital phase shift circuit partially enter each other, and the digital phase shift circuit and the inverted digital phase shift circuit that are adjacent to each other in the longitudinal direction in the second row are cascade-connected such that the digital phase shift circuit and the inverted digital phase shift circuit partially enter each other.

In addition, an aspect 12 of the present invention relates to the digital phase shifter according to the aspect 10 or 11, in which the connection portion includes a signal line connection path configured to connect the signal line included in the first row and the signal line included in the second row, and a pair of ground line connection paths disposed with a spacing on both sides of the signal line connection path.

In addition, an aspect 13 of the present invention relates to the digital phase shifter according to the aspect 12, in which the connection portion further includes a ground layer disposed on at least one of an upper side or a lower side of the signal line connection path and the pair of ground line connection paths, and a connection conductor configured to connect the pair of ground line connection paths and the ground layer.

In addition, an aspect 14 of the present invention relates to the digital phase shifter according to the aspect 10 or 11, in which the connection portion includes a first element connected in series between the signal line included in the first row and the signal line included in the second row, and a pair of second elements connected in parallel on both sides of the first element, and of the first element and the second elements, one element is a coil, and the other element is a capacitor.

In addition, an aspect 15 of the present invention relates to the digital phase shifter according to the aspect 10 or 11, in which the connection portion includes a third element connected in parallel between the signal line included in the first row and the signal line included in the second row, and a pair of fourth elements connected in series on both sides of the third element, and of the third element and the fourth elements, one element is a coil, and the other element is a capacitor.

### Advantageous Effects of Invention

According to the above-described aspects of the present invention, it is possible to provide the digital phase shift circuit and the digital phase shifter capable of achieving both the size reduction and the expansion of the difference between the phase in the low-latency mode and the phase in the high-latency mode.

### BRIEF DESCRIPTION OF DRAWINGS

[FIG. 1] A plan view showing a digital phase shift circuit according to a first embodiment of the present invention.
[FIG. 2] A cross-sectional view taken along a line II-II shown in FIG. 1.
[FIG. 3] A cross-sectional view taken along a line 111-111 in FIG. 1.
[FIG. 4] A plan view showing a digital phase shift circuit according to a second embodiment of the present invention.
[FIG. 5] A plan view showing a digital phase shift circuit according to a third embodiment of the present invention.
[FIG. 6] A plan view showing a digital phase shifter according to a fourth embodiment of the present invention.
[FIG. 7] A plan view showing a digital phase shifter according to a fifth embodiment of the present invention.
[FIG. 8] A plan view showing a digital phase shifter according to a sixth embodiment of the present invention.
[FIG. 9] A cross-sectional view taken along a line IX-IX shown in FIG. 8.
[FIG. 10] A plan view showing a digital phase shifter according to a seventh embodiment of the present invention.
[FIG. 11] A diagram showing an equivalent circuit of a connection portion according to the seventh embodiment of the present invention.
[FIG. 12] A diagram showing an equivalent circuit of a connection portion according to a modification example of the seventh embodiment of the present invention.

### DESCRIPTION OF EMBODIMENTS

Hereinafter, embodiments of the present invention will be described with reference to the drawings.

### (First Embodiment)

A digital phase shift circuit B according to a first embodiment is a high-frequency circuit that receives a high-frequency signal such as microwaves, quasi-millimeter waves, or millimeter waves as an input and outputs a high-frequency signal of which a phase is shifted by a predetermined phase shift amount, to the outside.

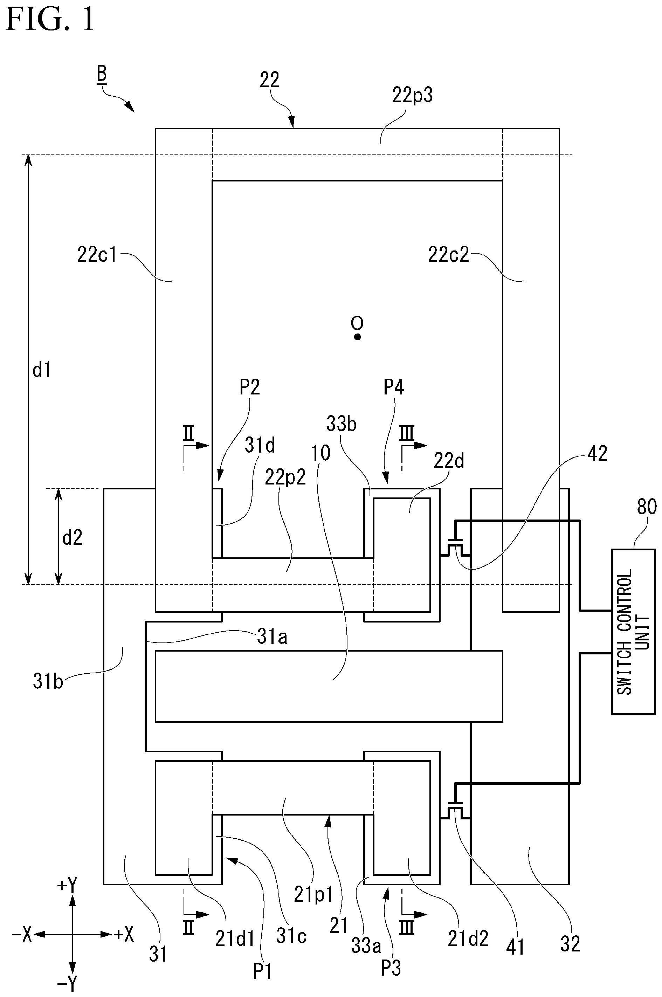

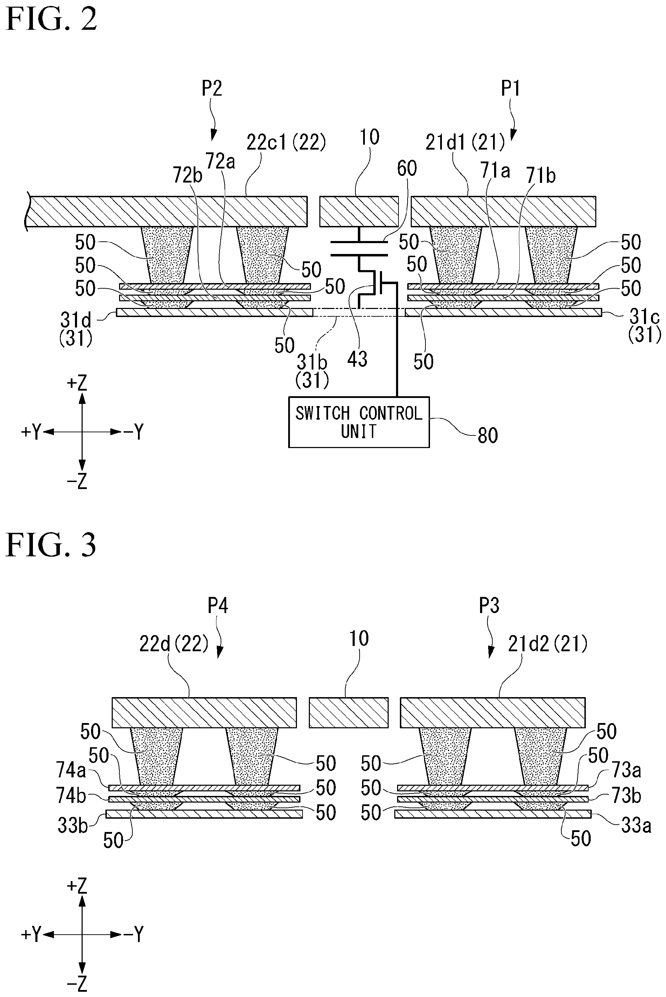

As shown in FIG. 1, the digital phase shift circuit B according to the present embodiment includes a signal line 10, a first line 21, a second line 22, a first ground conductor 31, and a second ground conductor 32. The first line 21 according to the present embodiment includes a first parallel line 21p1 and a pair of upper pads 21d1 and 21d2. The second line 22 according to the present embodiment includes a second parallel line 22p2, a first intersecting line 22c1, a third parallel line 22p3, a second intersecting line 22c2, and an upper pad 22d. In addition, the digital phase shift circuit B according to the present embodiment includes three electronic switches 41 to 43, a plurality of connection conductors 50, a capacitor 60, and a plurality of connection pads P1 to P4 (see also FIGS. 2 and 3).

As shown in FIG. 1, the signal line 10 is a linear strip-shaped conductor extending in one direction. That is, the signal line 10 is an elongated plate-shaped conductor having a constant width, a constant thickness, and a predetermined length. In the signal line 10, a signal current flows from a left side of a paper surface to a right side of the paper surface in FIG. 1, that is, from an end portion (input end) on the left side of the paper surface to an end portion (output end) on the right side of the paper surface. This signal current is a high-frequency signal having a wavelength range of the microwaves, the quasi-millimeter waves, or the millimeter waves as described above.

### <Definitions of Directions>

Here, in the present embodiment, a longitudinal direction of the signal line 10 (a direction in which the signal line 10 extends) will be simply referred to as a longitudinal direction X. A direction from the input end to the output end of the signal line 10 along the longitudinal direction X will be referred to as a +X direction or a right side. A direction opposite to the right side will be referred to as a left side or a -X direction. A direction intersecting (for example, orthogonal to) the signal line 10 will be referred to as an intersection direction Y. One direction along the intersection direction Y will be referred to as a rear side or a +Y direction. A direction opposite to the rear side will be referred to as a front side or a -Y direction. A direction intersecting (for example, orthogonal to) both the longitudinal direction X and the intersection direction Y will be referred to as an up-down direction Z. One direction along the up-down direction Z will be referred to as an upper side or a +Z direction. A direction opposite to the upper side will be referred to as a lower side or a -Z direction. A view in the up-down direction Z will be referred to as a plan view. In addition, the up-down direction Z need not coincide with a vertical direction. In addition, the "upper side" and the "lower side" need not coincide with an upper side and a lower side in the vertical direction. In addition, the +X direction and the -X direction may be defined as a left side and a right side instead of defining the +X direction and the -X direction as a right side and a left side.

The signal line 10 has, electrically, an inductance L1 as a distributed circuit constant. The inductance L1 is a parasitic inductance having magnitude corresponding to a shape of the signal line 10, such as a length of the signal line 10. In addition, the signal line 10 also has, electrically, a capacitance C1 as a distributed constant circuit. The capacitance C1 is a parasitic capacitance between the signal line 10 and a first parallel line 21p1 (details will be described below), between the signal line 10 and a second parallel line 22p2 (details will be described below), between the signal line 10 and a third parallel line 22p3 (details will be described below), between the signal line 10 and a silicon substrate (not shown), and the like.

In the following description, one side (+Y side) of the signal line 10 in the Y direction will be referred to as a first side of the signal line 10, and the other side (-Y side) of the signal line 10 in the Y direction will be referred to as a second side of the signal line 10. The first parallel line 21p1 is a linear strip-shaped conductor provided on the second side (-Y side) of the signal line 10. The first parallel line 21p1 is an elongated plate-shaped conductor having a constant width, a constant thickness, and a predetermined length. The first parallel line 21p1 extends parallel to the signal line 10 (in the longitudinal direction X). The first parallel line 21p1 and the signal line 10 are disposed with a spacing in the intersection direction Y. Among the ends of the first parallel line 21p1, an end located on the -X side will be referred to as a first end (one end), and an end located on the +X side will be referred to as a second end (the other end). Among the side edges of the first parallel line 21p1, a side edge located on the +Y side will be referred to as a first side edge (one side edge), and a side edge located on the -Y side will be referred to as a second side edge (the other side edge).

The upper pad 21d1 is a rectangular flat plate conductor connected to the first end (-X side) of the first parallel line 21p1. Long sides of the upper pad 21d1 extend in the intersection direction Y, and short sides of the upper pad 21d1 extend in the longitudinal direction X. Among the short sides of the upper pad 21d1, a short side located on the +Y side will be referred to as a first short side (one short side), and a short side located on the -Y side will be referred to as a second short side (the other short side). The first short side (+Y side) of the upper pad 21d1 is located at substantially the same position as the first side edge (+Y side) of the first parallel line 21p1. In addition, the second short side (-Y side) of the upper pad 21d1 is located on the front side (-Y side) with respect to the second side edge (-Y side) of the first parallel line 21p1.

That is, a dimension of the upper pad 21d1 in the intersection direction Y is greater than a width (a dimension in the intersection direction Y) of the first parallel line 21p1.

The upper pad 21d2 is a rectangular flat plate conductor connected to the second end (+X side) of the first parallel line 21p1. Long sides of the upper pad 21d2 extend in the intersection direction Y, and short sides of the upper pad 21d2 extend in the longitudinal direction X. Among the short sides of the upper pad 21d2, a short side located on the +Y side will be referred to as a first short side (one short side), and a short side located on the -Y side will be referred to as a second short side (the other short side). The first short side (+Y side) of the upper pad 21d2 is located at substantially the same position as the first side edge (+Y side) of the first parallel line 21p1. In addition, the second short side (-Y side) of the upper pad 21d2 is located on the front side (-Y side) with respect to the second side edge (-Y side) of the first parallel line 21p1.

That is, a dimension of the upper pad 21d2 in the intersection direction Y is greater than a width (a dimension in the intersection direction Y) of the first parallel line 21p1.

The second parallel line 22p2 is a linear strip-shaped conductor provided on the first side (+Y side) of the signal line 10. The second parallel line 22p2 is an elongated plate-shaped conductor having a constant width, a constant thickness, and a predetermined length. The second parallel line 22p2 extends parallel to the signal line 10 (in the longitudinal direction X). The second parallel line 22p2 and the signal line 10 are disposed with a spacing in the intersection direction Y. Among the ends of the second parallel line 22p2, an end located on the -X side will be referred to as a first end (one end), and an end located on the +X side will be referred to as a second end (the other end). Among the side edges of the second parallel line 22p2, a side edge located on the -Y side will be referred to as a first side edge (one side edge), and a side edge located on the +Y side will be referred to as a second side edge (the other side edge).

The second parallel line 22p2 is provided on an opposite side to the first parallel line 21p1 with respect to the signal line 10. In other words, the second parallel line 22p2 is disposed such that the signal line 10 is located between the first parallel line 21p1 and the second parallel line 22p2 in the intersection direction Y.

The first intersecting line 22c1 is a linear strip-shaped conductor connected to the first end (-X side) of the second parallel line 22p2. The first intersecting line 22c1 is an elongated plate-shaped conductor having a constant width, a constant thickness, and a predetermined length. The first intersecting line 22c1 extends away from the signal line 10 from the first end (-X side) of the second parallel line 22p2 in the intersection direction Y. That is, the first intersecting line 22c1 according to the present embodiment extends toward the rear side (+Y side) from the first end (-X side) of the second parallel line 22p2. An end edge (-Y side) of the first intersecting line 22c1 on the front side is located at substantially the same position as the first side edge (-Y side) of the second parallel line 22p2. Among the ends of the first intersecting line 22c1, an end located on the +Y side will be referred to as a first end (one end), and an end located on the -Y side will be referred to as a second end (the other end).

The upper pad 22d is a rectangular flat plate conductor connected to the second end (+X side) of the second parallel line 22p2. Long sides of the upper pad 22d extend in the intersection direction Y, and short sides of the upper pad 22d extend in the longitudinal direction X. Among the short sides of the upper pad 22d, a short side located on the -Y side will be referred to as a first short side (one short side), and a short side located on the +Y side will be referred to as a second short side (the other short side).

The first short side (-Y side) of the upper pad 22d is located at substantially the same position as the first side edge (-Y side) of the second parallel line 22p2. In addition, the second short side (+Y side) of the upper pad 22d is located on the rear side (+Y side) with respect to the second side edge (+Y side) of the second parallel line 22p2. That is, a dimension of the upper pad 22d in the intersection direction Y is greater than a width (dimension in the intersection direction Y) of the second parallel line 22p2.

The third parallel line 22p3 is a linear strip-shaped conductor connected to the first end (+Y side) of the first intersecting line 22c1. The third parallel line 22p3 is an elongated plate-shaped conductor having a constant width, a constant thickness, and a predetermined length. The third parallel line 22p3 extends parallel to the signal line 10 (in the longitudinal direction X) from the first end (+Y side) of the first intersecting line 22c1. That is, the third parallel line 22p3 according to the present embodiment extends toward the right side (+X side) from the first end (+Y side) of the first intersecting line 22c1. Among the ends of the third parallel line 22p3, an end located on the +X side will be referred to as a first end (one end), and an end located on the -X side will be referred to as a second end (the other end).

The third parallel line 22p3 is provided at a position farther from the signal line 10 than the second parallel line 22p2 on the first side (+Y side) of the signal line 10. In other words, the third parallel line 22p3 is disposed such that the second parallel line 22p2 is located between the signal line 10 and the third parallel line 22p3 in the intersection direction Y.

As shown in FIG. 1, in the intersection direction Y, a distance d1 between a center line of the second parallel line 22p2 and a center line of the third parallel line 22p3 is greater than a distance d2 between the center line of the second parallel line 22p2 and the outer edge (an outer edge on the third parallel line 22p3 side) on the rear side of the first ground conductor 31. In addition, a right end of the third parallel line 22p3 (that is, the first end (+X side) of the third parallel line 22p3) is located on the right side (+X side) with respect to the long side of the upper pad 22d of the second line 22 on the right side (+X side).

The second intersecting line 22c2 is a linear strip-shaped conductor connected to the first end (+X side) of the third parallel line 22p3. The second intersecting line 22c2 is an elongated plate-shaped conductor having a constant width, a constant thickness, and a predetermined length. The second intersecting line 22c2 extends toward the signal line 10 in the intersection direction Y from the first end (+X side) of the third parallel line 22p3. That is, the second intersecting line 22c2 according to the present embodiment extends toward the front side (-Y side) from the first end (+X side) of the third parallel line 22p3. Among the ends of the second intersecting line 22c2, an end located on the - Y side will be referred to as a first end (one end), and an end located on the +Y side will be referred to as a second end (the other end).

A first end edge (-Y side) of the second intersecting line 22c2 according to the present embodiment is located at substantially the same position as the first short side (-Y side) of the upper pad 22d and the first side edge (-Y side) of the second parallel line 22p2. In addition, the upper pad 22d and the second intersecting line 22c2 are disposed with a spacing in the longitudinal direction X. In addition, a left side edge (-X side) of the second intersecting line 22c2 according to the present embodiment is located at substantially the same position as a right end edge (+X side) of the signal line 10.

In addition, a first end (-Y side) of the second intersecting line 22c2 according to the present embodiment is always electrically connected to the second ground conductor 32 by a conductor (not shown). In other words, one end of the second line 22 is always electrically connected to the second ground conductor 32 by a conductor (not shown).

The first intersecting line 22c1, the third parallel line 22p3, and the second intersecting line 22c2 described above constitute a loop line that is looped in a U-shape to be convex toward the rear side (+Y side).

The first ground conductor 31 is a plate-shaped conductor that is provided on the input end side (-X side) of the signal line 10. The first ground conductor 31 is electrically grounded. In addition, a rectangular notch 31a is formed on a side edge of the first ground conductor 31 on the right side (+X side). In the present embodiment, the notch 31a is formed so that the first ground conductor 31 and the signal line 10 do not overlap each other in the longitudinal direction X.

In addition, in the present embodiment, a portion of the first ground conductor 31 located on the left side (-X side) with respect to the notch 31a will be referred to as a "base portion 31b", a portion of the first ground conductor 31 located on the front side (-Y side) with respect to the notch 31a will be referred to as a "first protrusion portion 31c", and a portion of the first ground conductor 31 located on the rear side (+Y side) with respect to the notch 31a will be referred to as a "second protrusion portion 31d". Each of the first protrusion portion 31c and the second protrusion portion 31d protrudes toward the right side (+X side) from the base portion 31b.

Each of the first protrusion portion 31c and the second protrusion portion 31d has a rectangular shape in which long sides extend in the intersection direction Y and short sides extend in the longitudinal direction X. The first protrusion portion 31c overlaps the upper pad 21d1 in the up-down direction Z. The second protrusion portion 31d overlaps an end portion of the first intersecting line 22c1 on the front side (-Y side) in the up-down direction Z. As shown in FIG. 2, the first ground conductor 31 is located below the signal line 10, the first line 21 (upper pad 21d1), and the second line 22 (first intersecting line 22c1).

The second ground conductor 32 is a plate-shaped conductor that is provided on the output end side (+X side) of the signal line 10. The second ground conductor 32 is electrically grounded. Although detailed illustration is omitted, the second ground conductor 32 is located below the signal line 10 and the second line 22 (second intersecting line 22c2).

As shown in FIG. 2, a first connection pad P1 includes the upper pad 21d1 described above, an upper intermediate pad 71a, a lower intermediate pad 71b, and the first protrusion portion 31c described above. The upper pad 21d1, the upper intermediate pad 71a, the lower intermediate pad 71b, and the first protrusion portion 31c overlap each other in a plan view. In addition, the upper pad 21d1, the upper intermediate pad 71a, the lower intermediate pad 71b, and the first protrusion portion 31c are arranged in that order from the upper side (+Z side) to the lower side (-Z side) and are disposed with spacings in the up-down direction Z.

Although detailed illustration is omitted, the upper pad 21d1, the upper intermediate pad 71a, the lower intermediate pad 71b, and the first protrusion portion 31c according to the present embodiment have substantially the same shape as each other. That is, the positions and the dimensions of the upper pad 21d1, the upper intermediate pad 71a, the lower intermediate pad 71b, and the first protrusion portion 31c in the longitudinal direction X and the intersection direction Y are substantially the same as each other. In FIG. 1, the dimensions of the first protrusion portion 31c are shown to be large to improve visibility of each component.

As shown in FIG. 2, the upper pad 21d1 and the upper intermediate pad 71a are electrically and mechanically connected to each other through a plurality of connection conductors 50. In addition, the upper intermediate pad 71a and the lower intermediate pad 71b are electrically and mechanically connected to each other through the plurality of connection conductors 50. In addition, the lower intermediate pad 71b and the first protrusion portion 31c are electrically and mechanically connected to each other through the plurality of connection conductors 50. As a result, the first connection pad P1 is always electrically connected to the first end (-X side) of the first parallel line 21p1 and the first ground conductor 31.

In the present specification, the "connection conductor 50" is a conductor extending in the up-down direction Z, and is a member that electrically and mechanically connects a member connected to an upper end of the connection conductor 50 and a member connected to a lower end of the connection conductor 50. The connection conductor 50 is, for example, a via that penetrates an insulating layer (not shown) in the up-down direction Z.

As shown in FIG. 2, a second connection pad P2 includes an end portion of the first intersecting line 22c1 described above on the front side (-Y side), an upper intermediate pad 72a, a lower intermediate pad 72b, and the second protrusion portion 31d described above. The end portion of the first intersecting line 22c1 on the front side (-Y side), the upper intermediate pad 72a, the lower intermediate pad 72b, and the second protrusion portion 31d overlap each other in a plan view. In addition, the end portion of the first intersecting line 22c1 on the front side (-Y side), the upper intermediate pad 72a, the lower intermediate pad 72b, and the second protrusion portion 31d are arranged in that order from the upper side (+Z side) to the lower side (-Z side) and are disposed with spacings in the up-down direction Z.

Although detailed illustration is omitted, the upper intermediate pad 72a, the lower intermediate pad 72b, and the second protrusion portion 31d according to the present embodiment have substantially the same shape as each other. That is, the positions and the dimensions of the upper intermediate pad 72a, the lower intermediate pad 72b, and the second protrusion portion 31d in the longitudinal direction X and the intersection direction Y are substantially the same as each other. In FIG. 1, the dimensions of the second protrusion portion 31d are shown to be large to improve visibility of each component.

As shown in FIG. 2, the end portion of the first intersecting line 22c1 on the front side (-Y side) and the upper intermediate pad 72a are electrically and mechanically connected to each other through the plurality of connection conductors 50. In addition, the upper intermediate pad 72a and the lower intermediate pad 72b are electrically and mechanically connected to each other through the plurality of connection conductors 50. In addition, the lower intermediate pad 72b and the second protrusion portion 31d are electrically and mechanically connected to each other through the plurality of connection conductors 50. As a result, the second connection pad P2 is always electrically connected to the first end (-X side) of the second parallel line 22p2 and the first ground conductor 31.

As shown in FIG. 3, a third connection pad P3 includes the upper pad 21d2 described above, an upper intermediate pad 73a, a lower intermediate pad 73b, and a lower pad 33a. The upper pad 21d2, the upper intermediate pad 73a, the lower intermediate pad 73b, and the lower pad 33a overlap each other in a plan view. In addition, the upper pad 21d2, the upper intermediate pad 73a, the lower intermediate pad 73b, and the lower pad 33a are arranged in that order from the upper side (+Z side) to the lower side (-Z side) and are disposed with spacings in the up-down direction Z.

Here, as shown in FIG. 1, the lower pad 33a is a rectangular flat plate conductor in which long sides extend in the intersection direction Y and short sides extend in the longitudinal direction X. The lower pad 33a is provided separately from the second ground conductor 32. The presence or absence of the electrical connection between the lower pad 33a and the second ground conductor 32 is switched depending on a state of a first electronic switch 41. Therefore, the presence or absence of the electrical grounding of the lower pad 33a is switched depending on the state of the first electronic switch 41.

Although detailed illustration is omitted, the upper pad 21d2, the upper intermediate pad 73a, the lower intermediate pad 73b, and the lower pad 33a according to the present embodiment have substantially the same shape as each other. That is, the positions and the dimensions of the upper pad 21d2, the upper intermediate pad 73a, the lower intermediate pad 73b, and the lower pad 33a in the longitudinal direction X and the intersection direction Y are substantially the same as each other. In FIG. 1, the dimensions of the lower pad 33a are shown to be large to improve visibility of each component.

As shown in FIG. 3, the upper pad 21d2 and the upper intermediate pad 73a are electrically and mechanically connected to each other through the plurality of connection conductors 50. In addition, the upper intermediate pad 73a and the lower intermediate pad 73b are electrically and mechanically connected to each other through the plurality of connection conductors 50. In addition, the lower intermediate pad 73b and the lower pad 33a are electrically and mechanically connected to each other through the plurality of connection conductors 50. As a result, the third connection pad P3 is always electrically connected to the second end (+X side) of the first parallel line 21p1 and the first electronic switch 41.

As shown in FIG. 3, a fourth connection pad P4 includes the upper pad 22d described above, an upper intermediate pad 74a, a lower intermediate pad 74b, and a lower pad 33b. The upper pad 22d, the upper intermediate pad 74a, the lower intermediate pad 74b, and the lower pad 33b overlap each other in a plan view. In addition, the upper pad 22d, the upper intermediate pad 74a, the lower intermediate pad 74b, and the lower pad 33b are arranged in that order from the upper side (+Z side) to the lower side (-Z side) and are disposed with spacings in the up-down direction Z.

Here, as shown in FIG. 1, the lower pad 33b is a rectangular flat plate conductor in which long sides extend in the intersection direction Y and short sides extend in the longitudinal direction X. The lower pad 33b is provided separately from the second ground conductor 32 and the lower pad 33a. The presence or absence of the electrical connection between the lower pad 33b and the second ground conductor 32 is switched depending on a state of a second electronic switch 42. Therefore, the presence or absence of the electrical ground is switched depending on the state of the second electronic switch 42 in the lower pad 33b.

Although detailed illustration is omitted, the upper pad 22d, the upper intermediate pad 74a, the lower intermediate pad 74b, and the lower pad 33b according to the present embodiment have substantially the same shape as each other. That is, the positions and the dimensions of the upper pad 22d, the upper intermediate pad 74a, the lower intermediate pad 74b, and the lower pad 33b in the longitudinal direction X and the intersection direction Y are substantially the same as each other. In FIG. 1, the dimensions of the lower pad 33b are shown to be large to improve visibility of each component.

Here, as described above, the dimension of the upper pad 22d in the intersection direction Y is greater than the width (the dimension in the intersection direction Y) of the second parallel line 22p2 (see also FIG. 1). Therefore, the maximum value of the dimension of the fourth connection pad P4 in the intersection direction Y is greater than the width (the dimension in the intersection direction Y) of the second parallel line 22p2.

In addition, as described above, the first end edge (-Y side) of the second intersecting line 22c2 according to the present embodiment is located at substantially the same position as the first short side (-Y side) of the upper pad 22d (see also FIG. 1). Therefore, at least a part of the second intersecting line 22c2 and at least a part (in the present embodiment, the entirety) of the fourth connection pad P4 face each other in the longitudinal direction X.

For example, as shown in FIG. 2, the capacitor 60 is a parallel flat plate in which an upper electrode is connected to the signal line 10 and a lower electrode is connected to the first ground conductor 31 through a third electronic switch 43. The capacitor 60 has a capacitance Ca corresponding to the facing area of the parallel flat plate. That is, the capacitance Ca is a circuit constant provided between the signal line 10 and the first ground conductor 31. However, the capacitor 60 may be a comb-tooth type capacitor.

As shown in FIG. 1, the first electronic switch 41 is a transistor that openably and closably connects the lower pad 33a of the third connection pad P3 and the second ground conductor 32. As shown in FIG. 1, the first electronic switch 41 according to the present embodiment is, for example, a MOS type field effect transistor (FET), in which a drain terminal is connected to the lower pad 33a of the third connection pad P3, a source terminal is connected to the second ground conductor 32, and a gate terminal is connected to a switch control unit 80.

The first electronic switch 41 switches the conduction state between the drain terminal and the source terminal between the open state and the closed state based on a gate signal input to the gate terminal from the switch control unit 80. That is, the first electronic switch 41 turns the connection between the second end (+X side) of the first parallel line 21p1 and the second ground conductor 32 ON/OFF by the switch control unit 80.

As shown in FIG. 1, the second electronic switch 42 is a transistor that openably and closably connects the lower pad 33b of the fourth connection pad P4 and the second ground conductor 32. As shown in FIG. 1, the second electronic switch 42 according to the present embodiment is, for example, a MOS type FET, in which a drain terminal is connected to the lower pad 33b of the fourth connection pad P4, a source terminal is connected to the second ground conductor 32, and a gate terminal is connected to the switch control unit 80.

The second electronic switch 42 switches the conduction state between the drain terminal and the source terminal between the open state and the closed state based on a gate signal input to the gate terminal from the switch control unit 80. That is, the second electronic switch 42 turns the connection between the second end (+X side) of the second parallel line 22p2 and the second ground conductor 32 ON/OFF by the switch control unit 80.

As shown in FIG. 2, the third electronic switch 43 is a transistor that openably and closably connects the lower electrode of the capacitor 60 and the first ground conductor 31 (in FIG. 2, the base portion 31b). The third electronic switch 43 is, for example, a MOS type FET, in which a drain terminal is connected to the lower electrode of the capacitor 60, a source terminal is connected to the first ground conductor 31, and a gate terminal is connected to the switch control unit 80.

The third electronic switch 43 switches the conduction state between the drain terminal and the source between the open state and the closed state based on a gate signal input to the gate terminal from the switch control unit 80. That is, the third electronic switch 43 turns the connection between the lower electrode of the capacitor 60 and the first ground conductor 31 ON/OFF by the switch control unit 80.

The switch control unit 80 is a control circuit that controls the first electronic switch 41, the second electronic switch 42, and the third electronic switch 43 described above. The switch control unit 80 includes three output ports, and individually outputs the gate signals from each output port to the gate terminals of the first electronic switch 41, the second electronic switch 42, and the third electronic switch 43. That is, the switch control unit 80 controls the ON/OFF operations of the first electronic switch 41, the second electronic switch 42, and the third electronic switch 43 by using the gate signal.

Next, the operations of the digital phase shift circuit B configured as described above will be described.

In the digital phase shift circuit B according to the present embodiment, an operation mode is switched depending on the conduction states of the first to third electronic switches 41 to 43. That is, the operation mode of the digital phase shift circuit B includes a low-latency mode in which only the first electronic switch 41 and the second electronic switch 42 are set to the ON state by the switch control unit 80, and a high-latency mode in which only the third electronic switch 43 is set to the ON state by the switch control unit 80.

In the low-latency mode, the switch control unit 80 sets the first electronic switch 41 and the second electronic switch 42 to the ON state and sets the third electronic switch 43 to the OFF state. That is, in the low-latency mode, the phase at the output end (right end) becomes a first phase θ_{L}, smaller than a second phase θ_{H} in the high-latency mode, by a first propagation delay time T_{L} until the high-frequency signal propagates from the input end (left end) to the output end (right end) of the signal line 10. Hereinafter, the low-latency mode will be described in more detail.

By setting the first electronic switch 41 to the ON state, the second end (+X side) of the first parallel line 21p1 is connected to the second ground conductor 32 through the third connection pad P3 (see FIG. 1). On the other hand, the first end (-X side) of the first parallel line 21p1 is always connected to the first ground conductor 31 through the first connection pad P1 (see FIGS. 1 and 2). Therefore, the first parallel line 21p1 forms a first energization path in which the current can flow between the first end (-X side) and the second end (+X side) by connecting the second end (+X side) to the second ground conductor 32 through the first electronic switch 41.

In addition, by setting the second electronic switch 42 to the ON state, the second end (+X side) of the second parallel line 22p2 is connected to the second ground conductor 32 through the fourth connection pad P4 (see FIG. 1). On the other hand, the first end (-X side) of the second parallel line 22p2 is always connected to the first ground conductor 31 through the second connection pad P2 (see FIGS. 1 and 2). Therefore, the second parallel line 22p2 forms a second energization path in which the current can flow between the first end (-X side) and the second end (+X side) by connecting the second end (+X side) to the second ground conductor 32 through the second electronic switch 42.

In a state in which both ends of the first parallel line 21p1 and the second parallel line 22p2 are connected to each other, when a signal current flows from the input end toward the output end in the signal line 10, a return current is generated in the first parallel line 21p1 and the second parallel line 22p2 due to the propagation of the signal current. The return current flows through the first parallel line 21p1 and the second parallel line 22p2 from the second end (+X side) to the first end (-X side).

That is, in the first parallel line 21p1 forming the first energization path, a first return current flows in a direction opposite to the energization direction of the signal current due to the energization of the signal current in the signal line 10. In addition, in the second parallel line 22p2 forming the second energization path, a second return current flows in a direction opposite to the energization direction of the signal current, that is, the same direction as the first return current, due to the energization of the signal current in the signal line 10.

Here, both the first return current flowing through the first parallel line 21p1 and the second return current flowing through the second parallel line 22p2 flow in a direction opposite to the energization direction of the signal current. Therefore, the first return current and the second return current act to reduce the inductance L1 of the signal line 10 due to electromagnetic coupling between the signal line 10 and the first parallel line 21p1 and electromagnetic coupling between the signal line 10 and the second parallel line 22p2. In a case in which the reduction amount of the inductance L1 is ΔLs, the effective inductance Lm of the signal line 10 is (L1 - ΔLs).

Further, the signal line 10 has the capacitance C1 as the parasitic capacitance as described above. In the low-latency mode, since the third electronic switch 43 is set to the OFF state, the capacitor 60 is not connected between the signal line 10 and the first ground conductor 31. That is, the capacitance Ca of the capacitor 60 does not affect the high-frequency signal propagating through the signal line 10. Therefore, the first propagation delay time T_{L} proportional to (Lm × C1)^{1/2} acts on the high-frequency signal propagating through the signal line 10.

The phase of the high-frequency signal at the output end of the signal line 10 is delayed by the first phase θ_{L} from the high-frequency signal at the input end of the signal line 10 due to such a first propagation delay time T_{L}. That is, in the low-latency mode, the inductance L1 of the signal line 10 is reduced to the inductance Lm due to the first return current and the second return current, and thus the original propagation delay time of the signal line 10 is reduced. As a result, the first phase θ_{L} smaller than the original phase of the signal line 10 is achieved.

On the other hand, in the high-latency mode, the switch control unit 80 sets the first electronic switch 41 and the second electronic switch 42 to the OFF state and sets the third electronic switch 43 to the ON state. That is, in the high-latency mode, the phase at the output end (right end) becomes the second phase θ_{H} that is greater than the first phase θ_{L} in the low-latency mode due to a second propagation delay time T_{H} until the high-frequency signal propagates from the input end (left end) to the output end (right end) of the signal line 10. Hereinafter, the high-latency mode will be described in more detail.

As described above, in the high-latency mode, the first electronic switch 41 and the second electronic switch 42 are set to the OFF state. Therefore, the above-described first conductive path is not formed in the first parallel line 21p1, and the above-described second conductive path is not formed in the second parallel line 22p2. Therefore, the first return current flowing through the first parallel line 21p1 becomes extremely small, and the second return current flowing through the second parallel line 22p2 becomes extremely small.

On the other hand, the end portion of the first intersecting line 22c1 on the front side (-Y side) is always connected to the first ground conductor 31 through the second connection pad P2 (see FIG. 2). In addition, as described above, the first end (-Y side) of the second intersecting line 22c2 is always connected to the second ground conductor 32. Therefore, a third energization path through which the current can flow from the first end (-Y side) of the second intersecting line 22c2 to the end portion on the front side (-Y side) of the first intersecting line 22c1 is formed in advance in the first intersecting line 22c1, the third parallel line 22p3, and the second intersecting line 22c2. Therefore, in the high-latency mode, a third return current flows from the first end (-Y side) of the second intersecting line 22c2 to the end portion on the front side (-Y side) of the first intersecting line 22c1 through the third parallel line 22p3 due to the signal current in the signal line 10.

Here, the third return current flows in a direction opposite to the energization direction of the signal current in the signal line 10 in the third parallel line 22p3 parallel to the signal line 10. In addition, the second intersecting line 22c2, the third parallel line 22p3, and the first intersecting line 22c1 through which the third return current flows constitute a loop line that is looped in a U-shape to be convex toward a side opposite to the signal line 10 (+Y side). Therefore, the inductance of the return path can be increased as compared with the configuration in the related art in which the return path (a path through which the third return current flows) does not constitute the loop line. As a result, the inductance of the transmission system can be increased.

The principle in which the third return current acts to increase the inductance of the return path can be described as follows. That is, a magnetic field generated in a case in which the third return current flows through the second intersecting line 22c2, a magnetic field generated in a case in which the third return current flows through the third parallel line 22p3, and a magnetic field generated in a case in which the third return current flows through the first intersecting line 22c1 are all in the same direction (+Z direction) at the center O (see FIG. 1) of the loop line. Therefore, these magnetic fields strengthen each other. Therefore, it is possible to increase the magnetic field generated by the third return current and to increase the inductance of the return path, as compared with the configuration in the related art in which the line through which the third return current flows does not constitute the loop line. In addition, by adjusting the height of the loop (that is, the position of the third parallel line 22p3 in the intersection direction Y and the lengths of the first intersecting line 22c1 and the second intersecting line 22c2), the value of the inductance of the return path can be significantly changed.

On the other hand, the signal line 10 has the capacitance C1 as the parasitic capacitance. In addition, in the high-latency mode, since the third electronic switch 43 is set to the ON state, the capacitor 60 is connected between the signal line 10 and the first ground conductor 31. That is, the signal line 10 has a capacitance Cb obtained by adding the capacitance Ca of the capacitor 60 and the capacitance C1 (parasitic capacitance). Therefore, the second propagation delay time T_{H} related to the increase in the inductance of the transmission system and the total capacitance Cb acts on the high-frequency signal propagating through the signal line 10.

The phase of the high-frequency signal at the output end of the signal line 10 is delayed by the second phase θ_{H} from the high-frequency signal at the input end of the signal line 10 due to such a second propagation delay time T_{H}. That is, in the high-latency mode, the original propagation delay time of the signal line 10 is increased by increasing the inductance of the transmission system due to the third return current. As a result, the second phase θ_{H} that is greater than the original phase of the signal line 10 is achieved.

As described above, the digital phase shift circuit B according to the present embodiment includes the signal line 10, the first line 21 including the first parallel line 21p1 extending parallel to the signal line 10, the second line 22 including the second parallel line 22p2 extending parallel to the signal line 10, the first intersecting line 22c1 extending away from the signal line 10 in the intersection direction Y from the first end portion (-X side) of the second parallel line 22p2, the third parallel line 22p3 extending parallel to the signal line 10 from the first end portion (+Y side) of the first intersecting line 22c1, and the second intersecting line 22c2 extending toward the signal line 10 in the intersection direction Y from the first end portion (+X side) of the third parallel line 22p3, the first ground conductor 31 electrically connected to the first end portion (-X side) of the first parallel line 21p1 and the first end portion (-X side) of the second parallel line 22p2, the second ground conductor 32 connected to the first end portion of the second line 22 (the first end portion (-Y side) of the second intersecting line 22c2), the first electronic switch 41 provided between the second end portion (+X side) of the first parallel line 21p1 and the second ground conductor 32, and the second electronic switch 42 provided between the second end portion (+X side) of the second parallel line 22p2 and the second ground conductor 32, in which the signal line 10 is located between the first parallel line 21p1 and the second parallel line 22p2.

With this configuration, the first intersecting line 22c1, the third parallel line 22p3, and the second intersecting line 22c2 constitute a loop line that is looped in a U-shape. Therefore, the magnetic field generated in a case in which the third return current flows through the second intersecting line 22c2, the magnetic field generated in a case in which the third return current flows through the third parallel line 22p3, and the magnetic field generated in a case in which the third return current flows through the first intersecting line 22c1 strengthen each other at the center O of the loop line. Therefore, it is possible to increase the magnetic field generated by the third return current and to increase the inductance of the return path as compared with the configuration in the related art in which the return path (the line through which the third return current flows) does not constitute the loop line. As a result, the inductance of the transmission system can be increased. That is, it is possible to sufficiently secure the difference (phase shift amount) between the phase θ_{L} in the low-latency mode and the phase θ_{H} in the high-latency mode without excessively increasing the size of the digital phase shift circuit B. In addition, by adjusting the height of the loop, the value of the inductance of the transmission system and the phase shift amount can be changed to a large extent without excessively increasing the size of the digital phase shift circuit B.

In addition, the digital phase shift circuit B according to the present embodiment further includes a fourth connection pad P4 provided between the second end portion (+X side) of the second parallel line 22p2 and the second electronic switch 42, in which the maximum value of the dimension of the fourth connection pad P4 in the intersection direction Y is greater than the width (dimension in the intersection direction Y) of the second parallel line 22p2. With this configuration, even in a case in which the size of the second electronic switch 42 is designed to be greater than the width of the second parallel line 22p2 for the purpose of adjusting the resistance loss or the like, the second parallel line 22p2 and the second electronic switch 42 can be stably connected to each other through the fourth connection pad P4.

In addition, at least a part of the second intersecting line 22c2 and at least a part of the fourth connection pad P4 face each other in the longitudinal direction X. With this configuration, the length of the second intersecting line 22c2 is sufficiently secured, and the value of the inductance of the return path (the inductance of the transmission system) is easily increased in the high-latency mode.

In addition, in the intersection direction Y, the distance d1 between the center line of the second parallel line 22p2 and the center line of the third parallel line 22p3 is greater than the distance d2 between the center line of the second parallel line 22p2 and the end portion of the first ground conductor 31 on the +Y side (the end portion on the third parallel line 22p3 side). With this configuration, the height of the loop of the loop line in which the third return current flows is sufficiently secured, and the value of the inductance of the return path (the inductance of the transmission system) is more easily increased in the high-latency mode.

Although, in the present embodiment, each of the first ground conductor 31 and the second ground conductor 32 has a single-layer structure, at least one of the first ground conductor 31 or the second ground conductor 32 may have a two-layer structure. With this configuration, the resistance value of the first ground conductor 31 or the second ground conductor 32 can be reduced, and the loss related to the return current flowing through the first ground conductor 31 or the second ground conductor 32 can be reduced. At least one of the first ground conductor 31 or the second ground conductor 32 may have a structure of three layers or more. The configuration in which the second ground conductor 32 has a multilayer structure is also suitable from the viewpoint that the first electronic switch 41 and the second electronic switch 42 are easily connected to the second ground conductor 32.

### (Second Embodiment)

Next, a second embodiment will be described, but the basic configuration is the same as the configuration of the first embodiment. Therefore, the same configurations are denoted by the same reference signs, the description thereof will be omitted, and only a difference will be described.

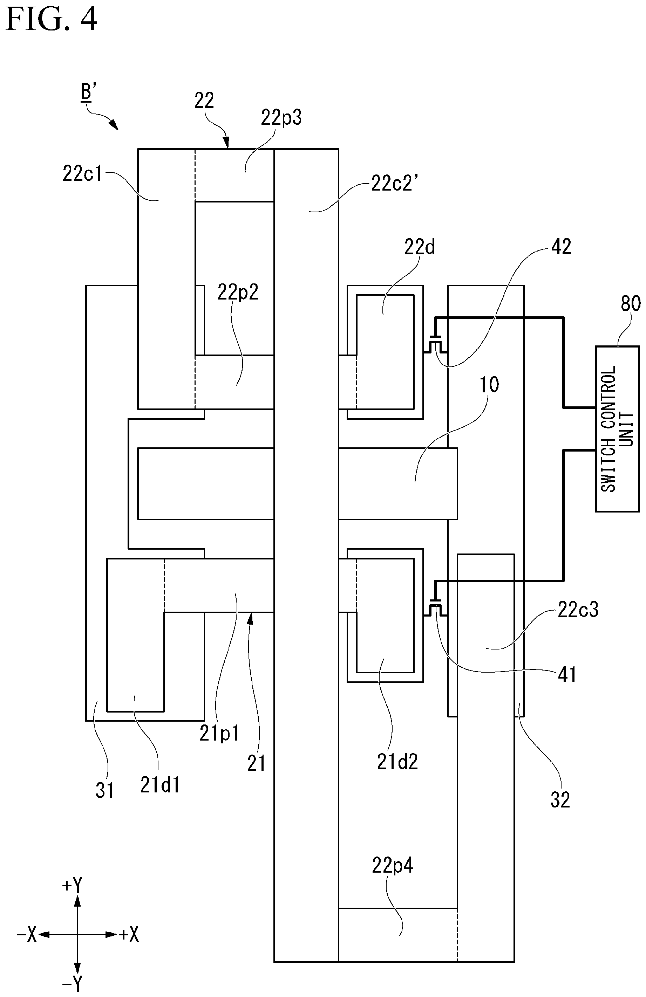

As shown in FIG. 4, in a digital phase shift circuit B' according to the present embodiment, the right end of the third parallel line 22p3 (that is, the first end (+X side) of the third parallel line 22p3) is located on the left side (-X side) with respect to the right end of the second parallel line 22p2 (that is, the second end (+X side) of the second parallel line 22p2). In addition, a second intersecting line 22c2' according to the present embodiment is different from the second intersecting line 22c2 according to the embodiment in that the second intersecting line 22c2' extends to intersect the second parallel line 22p2, the signal line 10, and the first parallel line 21p1 in a plan view.

The second intersecting line 22c2' is located above the second parallel line 22p2, the signal line 10, and the first parallel line 21p1 such that the second intersecting line 22c2' does not come into contact with these lines 22p2, 10, and 21p1. More specifically, the second intersecting line 22c2' is formed in another conductive layer that faces the conductive layer, in which the lines 22p2, 10, and 21p1 are formed, with an insulating layer interposed therebetween. In addition, the second intersecting line 22c2' is located above the third parallel line 22p3, and the second end (+Y side) of the second intersecting line 22c2' and the right end (+X side) of the third parallel line 22p3 are electrically connected to each other through a conductor (not shown) (for example, a via). The second intersecting line 22c2' may be located below the lines 22p2, 10, and 21p1. However, the configuration in which the second intersecting line 22c2' is located above the lines 22p2, 10, and 21pl is suitable from the viewpoint that the wiring is easily thickened and thus the resistance value of the wiring is easily lowered.

In addition, the second line 22 according to the present embodiment further includes a fourth parallel line 22p4 and a third intersecting line 22c3, in addition to the upper pad 22d, the second parallel line 22p2, the first intersecting line 22c1, the third parallel line 22p3, and the second intersecting line 22c2'. The fourth parallel line 22p4 and the third intersecting line 22c3 are located at the same positions as the second parallel line 22p2, the first intersecting line 22c1, and the third parallel line 22p3 in the up-down direction Z. That is, the fourth parallel line 22p4 and the third intersecting line 22c3 are formed in the same conductive layer as the second parallel line 22p2, the first intersecting line 22c1, and the third parallel line 22p3.

The fourth parallel line 22p4 is a linear strip-shaped conductor connected to the first end (-Y side) of the second intersecting line 22c2'. The fourth parallel line 22p4 is an elongated plate-shaped conductor having a constant width, a constant thickness, and a predetermined length. The fourth parallel line 22p4 extends parallel to the signal line 10 (in the longitudinal direction X) from the first end (-Y side) of the second intersecting line 22c2'. That is, the fourth parallel line 22p4 according to the present embodiment extends toward the right side (+X side) from the first end (-Y side) of the second intersecting line 22c2'. Among the ends of the fourth parallel line 22p4, an end located on the +X side will be referred to as a first end (one end), and an end located on the -X side will be referred to as a second end (the other end).

The first end (-Y side) of the second intersecting line 22c2' and the left end of the fourth parallel line 22p4 (that is, the second end (-X side) of the fourth parallel line 22p4) are electrically connected to each other through the conductor (not shown) (for example, a via).

The fourth parallel line 22p4 is provided at a position farther from the signal line 10 than the first parallel line 21p1 on the second side (-Y side) of the signal line 10. In other words, the fourth parallel line 22p4 is disposed such that the first parallel line 21p1 is located between the signal line 10 and the fourth parallel line 22p4 in the intersection direction Y. In addition, the right end of the fourth parallel line 22p4 (that is, the first end (+X side) of the fourth parallel line 22p4) is located to the right side (+X side) with respect to the long side of the upper pad 21d2 of the first line 21 on the right side (+X side).

The third intersecting line 22c3 is a linear strip-shaped conductor connected to the first end (+X side) of the fourth parallel line 22p4. The third intersecting line 22c3 is an elongated plate-shaped conductor having a constant width, a constant thickness, and a predetermined length. The third intersecting line 22c3 extends toward the signal line 10 in the intersection direction Y from the first end (+X side) of the fourth parallel line 22p4. That is, the third intersecting line 22c3 according to the present embodiment extends toward the rear side (+Y side) from the first end (+X side) of the fourth parallel line 22p4. Among the ends of the third intersecting line 22c3, an end located on the +Y side will be referred to as a first end (one end), and an end located on the -Y side will be referred to as a second end (the other end).

In addition, the upper pad 21d2 and the third intersecting line 22c3 are disposed with a spacing in the longitudinal direction X. In addition, the first end (+Y side) of the third intersecting line 22c3 according to the present embodiment is always electrically connected to the second ground conductor 32 through the conductor (not shown). In other words, one end of the second line 22 is always electrically connected to the second ground conductor 32 by a conductor (not shown).

In the digital phase shift circuit B' according to the present embodiment, similarly to the digital phase shift circuit B according to the first embodiment, the first intersecting line 22c1, the third parallel line 22p3, and the second intersecting line 22c2' constitute a loop line that is looped in a U-shape to be convex toward the rear side (+Y side). In addition, in the digital phase shift circuit B' according to the present embodiment, the second intersecting line 22c2', the fourth parallel line 22p4, and the third intersecting line 22c3 constitute a loop line that is looped in a U-shape to be convex toward the front side (-Y side). That is, the return path (the line through which the third return current flows) in the high-latency mode includes two loop lines. Therefore, it is possible to further increase the magnetic field generated by the third return current, and to further increase the inductance of the return path (the inductance of the transmission system).

As described above, in the digital phase shift circuit B' according to the present embodiment, the second intersecting line 22c2' extends to intersect the second parallel line 22p2, the signal line 10, and the first parallel line 21p1 in a plan view, and the second line 22 further includes the fourth parallel line 22p4 extending parallel to the signal line 10 from the first end portion of the second intersecting line 22c2', and the third intersecting line 22c3 extending toward the signal line 10 in the intersection direction Y from the first end portion of the fourth parallel line 22p4. With this configuration, the value of the inductance of the return path (the inductance of the transmission system) can be further increased in the high-latency mode, and the difference (phase shift amount) between the phase θ_{L} in the low-latency mode and the phase θ_{H} in the high-latency mode can be further increased.

### (Third Embodiment)

Next, a third embodiment will be described, but the basic configuration is the same as the configuration of the first embodiment. Therefore, the same configurations are denoted by the same reference signs, the description thereof will be omitted, and only a difference will be described.

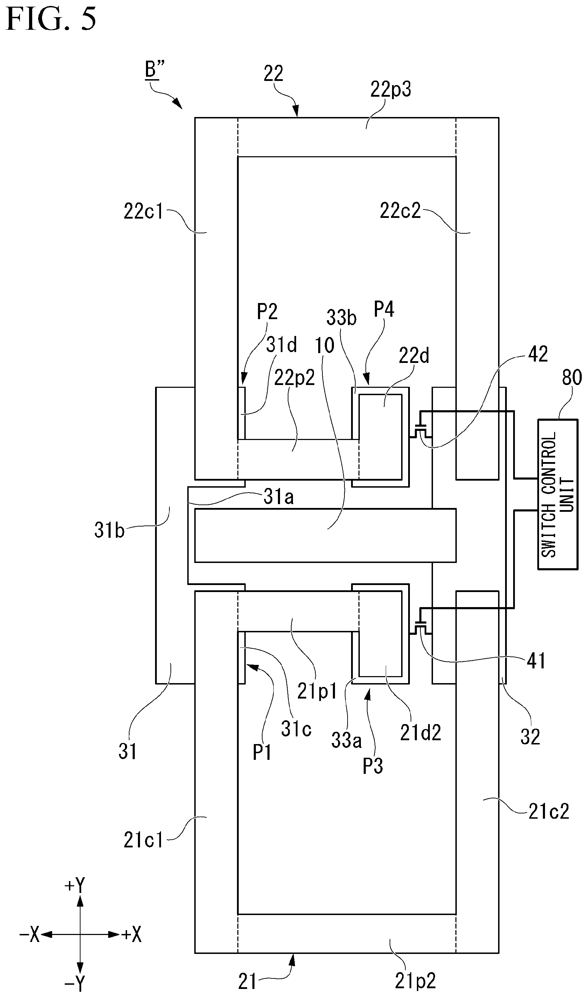

As shown in FIG. 5, a digital phase shift circuit B" according to the present embodiment has a different configuration of the first line 21 described in the first embodiment from the digital phase shift circuit B. Specifically, the first line 21 according to the present embodiment includes a fourth intersecting line 21c1, a fifth parallel line 21p2, and a fifth intersecting line 21c2, in addition to the first parallel line 21pl and the upper pad 21d2. The upper pad 21d1 is omitted. The fourth intersecting line 21c1, the fifth parallel line 21p2, and the fifth intersecting line 21c2 are located at the same positions as the first parallel line 21p1 and the upper pad 21d2 in the up-down direction Z. That is, the fourth intersecting line 21c1, the fifth parallel line 21p2, and the fifth intersecting line 21c2 are formed in the same conductive layer as the first parallel line 21p1 and the upper pad 21d2.

The fourth intersecting line 21c1 is a linear strip-shaped conductor connected to the first end (-X side) of the first parallel line 21p1. The fourth intersecting line 21c1 is an elongated plate-shaped conductor having a constant width, a constant thickness, and a predetermined length. The fourth intersecting line 21c1 extends away from the signal line 10 in the intersection direction Y from the first end (-X side) of the first parallel line 21p1. That is, the fourth intersecting line 21c1 in the present embodiment extends toward the front side (-Y side) from the first end (-X side) of the first parallel line 21p1.

The end edge (+Y side) on the rear side of the fourth intersecting line 21c1 is located at substantially the same position as the first side edge (+Y side) of the first parallel line 21p1. Among the ends of the fourth intersecting line 21c1, an end located on the -Y side will be referred to as a first end (one end), and an end located on the +Y side will be referred to as a second end (the other end).

The fifth parallel line 21p2 is a linear strip-shaped conductor connected to the first end (-Y side) of the fourth intersecting line 21c1. The fifth parallel line 21p2 is an elongated plate-shaped conductor having a constant width, a constant thickness, and a predetermined length. The fifth parallel line 21p2 extends parallel to the signal line 10 (in the longitudinal direction X) from the first end (-Y side) of the fourth intersecting line 21c1. That is, the fifth parallel line 21p2 in the present embodiment extends toward the right side (+X side) from the first end (-Y side) of the fourth intersecting line 21c1. Among the ends of the fifth parallel line 21p2, an end located on the +X side will be referred to as a first end (one end), and an end located on the -X side will be referred to as a second end (the other end).

The fifth parallel line 21p2 is provided at a position farther from the signal line 10 than the first parallel line 21p1 on the second side (-Y side) of the signal line 10. In other words, the fifth parallel line 21p2 is disposed such that the first parallel line 21p1 is located between the signal line 10 and the fifth parallel line 21p2 in the intersection direction Y.

As shown in FIG. 5, in the intersection direction Y, a distance between the center line of the first parallel line 21p1 and the center line of the fifth parallel line 21p2 is the same as (or similar to) the distance d1 (see FIG. 1) between the center line of the second parallel line 22p2 and the center line of the third parallel line 22p3. The right end (+X side) of the fifth parallel line 21p2 is located on the right side (+X side) with respect to the long side of the upper pad 21d2 on the right side (+X side).

The fifth intersecting line 21c2 is a linear strip-shaped conductor connected to the first end (+X side) of the fifth parallel line 21p2. The fifth intersecting line 21c2 is an elongated plate-shaped conductor having a constant width, a constant thickness, and a predetermined length. The fifth intersecting line 21c2 extends toward the signal line 10 in the intersection direction Y from the first end (+X side) of the fifth parallel line 21p2. That is, the fifth intersecting line 21c2 in the present embodiment extends toward the rear side (+Y side) from the first end (+X side) of the fifth parallel line 21p2. Among the ends of the fifth intersecting line 21c2, an end located on the -Y side will be referred to as a first end (one end), and an end located on the +Y side will be referred to as a second end (the other end).

The second end edge (+Y side) of the fifth intersecting line 21c2 in the present embodiment is located at substantially the same position as the first short side (+Y side) of the upper pad 21d2 and the first side edge (+Y side) of the first parallel line 21p1 in the intersection direction Y. In addition, the upper pad 21d2 and the fifth intersecting line 21c2 are disposed with a spacing in the longitudinal direction X. In addition, a left side edge (-X side) of the fifth intersecting line in the present embodiment is located at substantially the same position as the right end edge (+X side) of the signal line 10 in the longitudinal direction X.

In addition, the second end (+Y side) of the fifth intersecting line 21c2 in the present embodiment is always electrically connected to the second ground conductor 32 through the conductor (not shown). In other words, one end of the first line 21 is always electrically connected to the second ground conductor 32 through the conductor (not shown).

The fourth intersecting line 21c1, the fifth parallel line 21p2, and the fifth intersecting line 21c2 described above constitute a loop line that is looped in a U-shape to be convex toward the front side (-Y side).

In the digital phase shift circuit B" according to the present embodiment, similarly to the digital phase shift circuit B according to the first embodiment, the first intersecting line 22c1, the third parallel line 22p3, and the second intersecting line 22c2 constitute a loop line that is looped in a U-shape to be convex toward the rear side (+Y side). In addition, in the digital phase shift circuit B" according to the present embodiment, the fourth intersecting line 21c1, the fifth parallel line 21p2, and the fifth intersecting line 21c2 constitute a loop line that is looped in a U-shape to be convex toward the front side (-Y side). That is, the return path (the line through which the third return current flows) in the high-latency mode includes two loop lines. Therefore, it is possible to further increase the magnetic field generated by the third return current, and to further increase the inductance of the return path (the inductance of the transmission system).

As described above, in the digital phase shift circuit B" according to the present embodiment, the first line 21 further includes the fourth intersecting line 21c1 extending away from the signal line 10 in the intersection direction from the first end portion of the first parallel line 21p1, the fifth parallel line 21p2 extending parallel to the signal line 10 from the first end portion of the fourth intersecting line 21c1, and the fifth intersecting line 21c2 extending toward the signal line 10 in the intersection direction Y from the first end portion of the fifth parallel line 21p2. With this configuration, the value of the inductance of the return path (the inductance of the transmission system) can be further increased in the high-latency mode, and the difference (phase shift amount) between the phase θ_{L} in the low-latency mode and the phase θ_{H} in the high-latency mode can be further increased.

### (Fourth Embodiment)

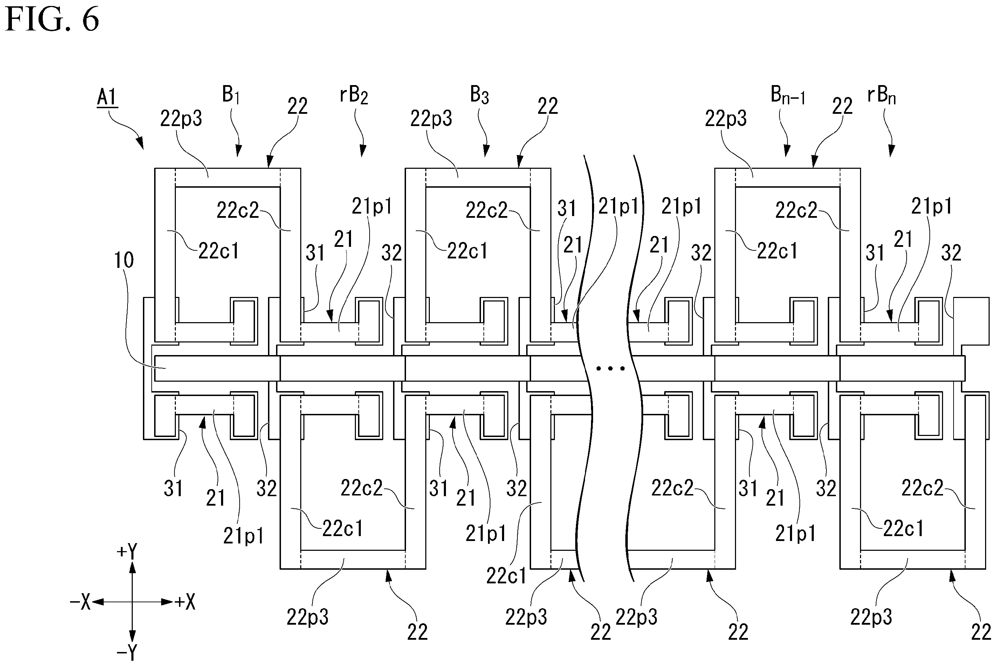

Next, a fourth embodiment will be described. As shown in FIG. 6, in a digital phase shifter A1 according to the fourth embodiment, a plurality of basic digital phase shift circuits B₁, B₃, ..., Bₙ₋₁ and a plurality of inverted digital phase shift circuits rB₂, ..., rBₙ are alternately cascade-connected in the longitudinal direction X. That is, in the digital phase shifter A1, a first digital phase shift circuit B₁, a second digital phase shift circuit rB₂, ..., and an n-th digital phase shift circuit rBₙ are cascade-connected in a row in the longitudinal direction X, a basic digital phase shift circuit B is adopted for the first digital phase shift circuit B₁, a third digital phase shift circuit B₃, ..., and an n-1th digital phase shift circuit Bₙ₋₁, and an inverted digital phase shift circuit rB is adopted for the second digital phase shift circuit rB₂, ..., and the n-th digital phase shift circuit rBₙ.

The digital phase shifter A1 outputs the high-frequency signal to the outside from the first digital phase shift circuit B₁ or the n-th digital phase shift circuit rBₙ. In addition, in order to improve visibility, the first electronic switch 41, the second electronic switch 42, and the switch control unit 80 are not shown in FIG. 6 and the subsequent drawings.

Here, the basic digital phase shift circuit B adopted as the first digital phase shift circuit B₁, the third digital phase shift circuit B₃, ..., and the n-1th digital phase shift circuit Bₙ₋₁ is basically the same as the digital phase shift circuit B according to the first embodiment, except that the second ground conductor 32 is also formed with the notch 31a (see FIG. 1) similar to the first ground conductor 31. Therefore, each configuration of the basic digital phase shift circuit B is denoted by the same reference sign as the configuration of the digital phase shift circuit B according to the first embodiment, and the detailed description thereof will be omitted.

On the other hand, the inverted digital phase shift circuit rB adopted as the second digital phase shift circuit rB₂, ..., and the n-th digital phase shift circuit rBₙ has a structure in which the basic digital phase shift circuit B is inverted with respect to the center line of the signal line 10. More specifically, the inverted digital phase shift circuit rB has a structure in which the basic digital phase shift circuit B is mirror-inverted in the intersection direction Y with respect to the center line of the signal line 10. In addition, each configuration of the inverted digital phase shift circuit rB is denoted by the same reference sign as the configuration of the basic digital phase shift circuit B, and the detailed description thereof will be omitted.

In the digital phase shifter A1 according to the present embodiment, each inverted digital phase shift circuit rB is connected to the basic digital phase shift circuit B adjacent to the left side (-X side) of the inverted digital phase shift circuit rB such that a part thereof enters the basic digital phase shift circuit B. More specifically, each inverted digital phase shift circuit rB is disposed such that the first intersecting line 22c1 included in the inverted digital phase shift circuit rB and the second intersecting line 22c2 included in the basic digital phase shift circuit B adjacent on the left side (-X side) are located on the same axis. For example, the first intersecting line 22c1 included in the second digital phase shift circuit rB₂ and the second intersecting line 22c2 included in the first digital phase shift circuit B₁ are located on the same axis as shown in FIG. 6.

**In** addition, each inverted digital phase shift circuit rB uses the second ground conductor 32 included in the basic digital phase shift circuit B adjacent to the left side (-X side) of the inverted digital phase shift circuit rB as its own first ground conductor 31. For example, as shown in FIG. 6, the second ground conductor 32 included in the first digital phase shift circuit B₁ functions as the first ground conductor 31 of the second digital phase shift circuit rB₂.

**In** addition, the first line 21 included in each inverted digital phase shift circuit rB is connected to the second line 22 included in the basic digital phase shift circuit B adjacent to the left side (-X side) of the inverted digital phase shift circuit rB. More specifically, the first parallel line 21p1 included in each inverted digital phase shift circuit rB and the second intersecting line 22c2 included in the basic digital phase shift circuit B adjacent to the left side (-X side) of the inverted digital phase shift circuit rB are directly connected to each other. For example, the first parallel line 21p1 included in the second digital phase shift circuit rB₂ and the second intersecting line 22c2 included in the first digital phase shift circuit B₁ are directly connected to each other, so that the first line 21 of the second digital phase shift circuit rB₂ and the second line 22 of the first digital phase shift circuit B₁ are connected to each other.

Similarly, in the digital phase shifter A1 according to the present embodiment, each basic digital phase shift circuit B is connected to the inverted digital phase shift circuit rB adjacent to the left side (-X side) of the basic digital phase shift circuit B such that a part thereof enters the inverted digital phase shift circuit rB. More specifically, the basic digital phase shift circuit B is disposed such that the first intersecting line 22c1 included in each basic digital phase shift circuit B and the second intersecting line 22c2 included in the inverted digital phase shift circuit rB adjacent on the left side (-X side) are located on the same axis. For example, the first intersecting line 22c1 included in the third digital phase shift circuit B₃ and the second intersecting line 22c2 included in the second digital phase shift circuit rB₂ are located on the same axis as shown in FIG. 6.

In addition, each basic digital phase shift circuit B uses a second ground conductor included in the inverted digital phase shift circuit rB adjacent to the left side (-X side) of the basic digital phase shift circuit B as its own first ground conductor 31. For example, the second ground conductor 32 included in the second digital phase shift circuit rB₂ functions as the first ground conductor 31 of the third digital phase shift circuit B₃ as shown in FIG. 6.

In addition, the first line 21 included in each basic digital phase shift circuit B is connected to the second line 22 included in the inverted digital phase shift circuit rB adjacent to the left side (-X side) of the basic digital phase shift circuit B. More specifically, the first parallel line 21p1 included in each basic digital phase shift circuit B and the second intersecting line 22c2 included in the inverted digital phase shift circuit rB adjacent to the left side (-X side) of the basic digital phase shift circuit B are directly connected to each other. For example, the first parallel line 21p1 included in the third digital phase shift circuit B₃ and the second intersecting line 22c2 included in the second digital phase shift circuit rB₂ are directly connected to each other, so that the first line 21 of the third digital phase shift circuit B₃ and the second line 22 of the second digital phase shift circuit rB₂ are connected to each other.

As described above, by alternately cascade-connecting the basic digital phase shift circuits B and the inverted digital phase shift circuits rB, as shown in FIG. 6, the third parallel line 22p3 included in the basic digital phase shift circuit B and the third parallel line 22p3 included in the inverted digital phase shift circuit rB are located on opposite sides with respect to the signal line 10 for the basic digital phase shift circuit B and the inverted digital phase shift circuit rB that are adjacent to each other. For example, for the first digital phase shift circuit B₁ and the second digital phase shift circuit rB₂, the third parallel line 22p3 included in the first digital phase shift circuit B₁ is located on the first side (+Y side) of the signal line 10, and the third parallel line 22p3 included in the second digital phase shift circuit rB₂ is located on the second side (-Y side) of the signal line 10. In addition, for the second digital phase shift circuit rB₂ and the third digital phase shift circuit B₃, the third parallel line 22p3 included in the second digital phase shift circuit rB₂ is located on the second side (-Y side) of the signal line 10, and the third parallel line 22p3 included in the third digital phase shift circuit B₃ is located on the first side (+Y side) of the signal line 10.

That is, in the digital phase shifter A1 according to the present embodiment, the basic digital phase shift circuits B and the inverted digital phase shift circuits rB are alternately cascade-connected such that the third parallel lines 22p3 are alternately disposed on the first side (+Y side) and the second side (-Y side) of the signal line 10 when viewed in the longitudinal direction X. Further, in other words, in the digital phase shifter A1 according to the present embodiment, the basic digital phase shift circuits B and the inverted digital phase shift circuits rB are alternately cascade-connected such that the return paths (loop lines in which the third return current flows) in the high-latency mode are alternately disposed on the first side (+Y side) and the second side (-Y side) of the signal line 10 when viewed in the longitudinal direction X.

As described above, by alternately cascade-connecting the basic digital phase shift circuits B and the inverted digital phase shift circuits rB, the third parallel lines 22p3 can be disposed apart from each other in the basic digital phase shift circuit B and the inverted digital phase shift circuit rB that are adjacent to each other. In other words, in the basic digital phase shift circuit B and the inverted digital phase shift circuit rB that are adjacent to each other, the return paths (the loop lines through which the third return current flows) in the high-latency mode can be disposed apart from each other. Therefore, the value of the inductance of the return path (the inductance of the transmission system) can be further increased in the high-latency mode.

As described above, the digital phase shifter A1 according to the present embodiment includes the plurality of basic digital phase shift circuits B and the plurality of inverted digital phase shift circuits rB in which the basic digital phase shift circuits B are inverted with respect to the center line of the signal line 10, in which the plurality of basic digital phase shift circuits B and the plurality of inverted digital phase shift circuits rB are alternately cascade-connected in the longitudinal direction X. With this configuration, the value of the inductance of the return path (the inductance of the transmission system) can be further increased in the high-latency mode, and the difference (phase shift amount) between the phase θ_{L} in the low-latency mode and the phase θ_{H} in the high-latency mode can be further increased.

In addition, the digital phase shift circuit B and the inverted digital phase shift circuit rB that are adjacent to each other in the longitudinal direction X are cascade-connected such that the digital phase shift circuit B and the inverted digital phase shift circuit rB partially enter each other. With this configuration, it is possible to achieve the size reduction in the digital phase shifter A1.

It has been described above that the first intersecting line 22c1 included in each inverted digital phase shift circuit rB and the second intersecting line 22c2 included in the basic digital phase shift circuit B adjacent to the left side (-X side) of the inverted digital phase shift circuit rB are located on the same axis, but the intersecting lines 22c1 and 22c2 need not be located on the same axis. In addition, it has been described that the first intersecting line 22c1 included in each basic digital phase shift circuit B and the second intersecting line 22c2 included in the inverted digital phase shift circuit rB adjacent to the left side (-X side) of the basic digital phase shift circuit B are located on the same axis, but the intersecting lines 22c1 and 22c2 need not be located on the same axis.

### (Fifth Embodiment)

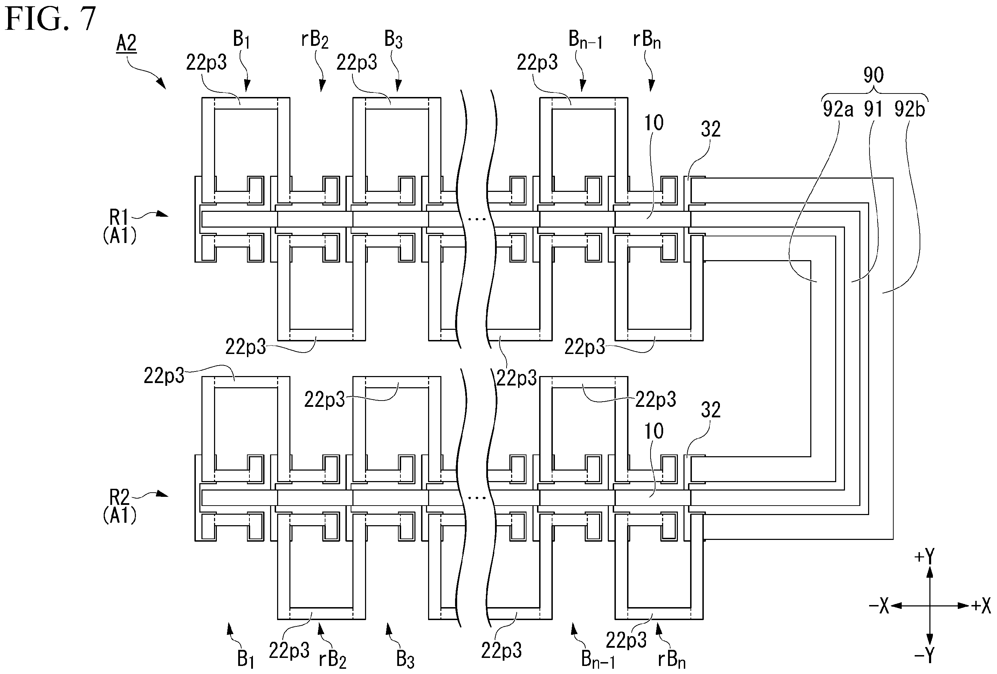

Next, a fifth embodiment will be described. As shown in FIG. 7, the digital phase shifter A2 according to the fifth embodiment includes a first row R1, a second row R2, and a connection portion 90 that electrically connects a first end (+X side) of the first row R1 and a first end (+X side) of the second row R2. The second row R2 extends parallel to the first row R1. The second row R2 is disposed to overlap the first row R1 when viewed in the intersection direction Y. Specifically, the second row R2 is located on the front side (-Y side) of the first row R1.

Here, each of the first row R1 and the second row R2 is obtained by alternately cascade-connecting the plurality of basic digital phase shift circuits B₁, B₃, ..., Bₙ₋₁ and the plurality of the inverted digital phase shift circuits rB₂, ..., rBₙ in the longitudinal direction X. That is, each of the structure of the first row R1 and the structure of the second row R2 is basically the same as in the digital phase shifter A1 according to the fourth embodiment. Therefore, each configuration of the first row R1 and the second row R2 is denoted by the same reference signs as the configuration of the digital phase shifter A1 according to the fourth embodiment, and the detailed description thereof will be omitted.

The connection portion 90 according to the present embodiment has a U-shape that is convex to the right (+X side), and connects the n-th digital phase shift circuit rBₙ included in the first row R1 and the n-th digital phase shift circuit rBₙ included in the second row R2. Specifically, the connection portion 90 according to the present embodiment constitutes a so-called coplanar line, and includes a signal line connection path 91 and a pair of ground line connection paths 92a and 92b disposed with a spacing on both sides of the signal line connection path 91. However, the connection portion 90 may constitute as a so-called grounded coplanar line or a microstrip line.

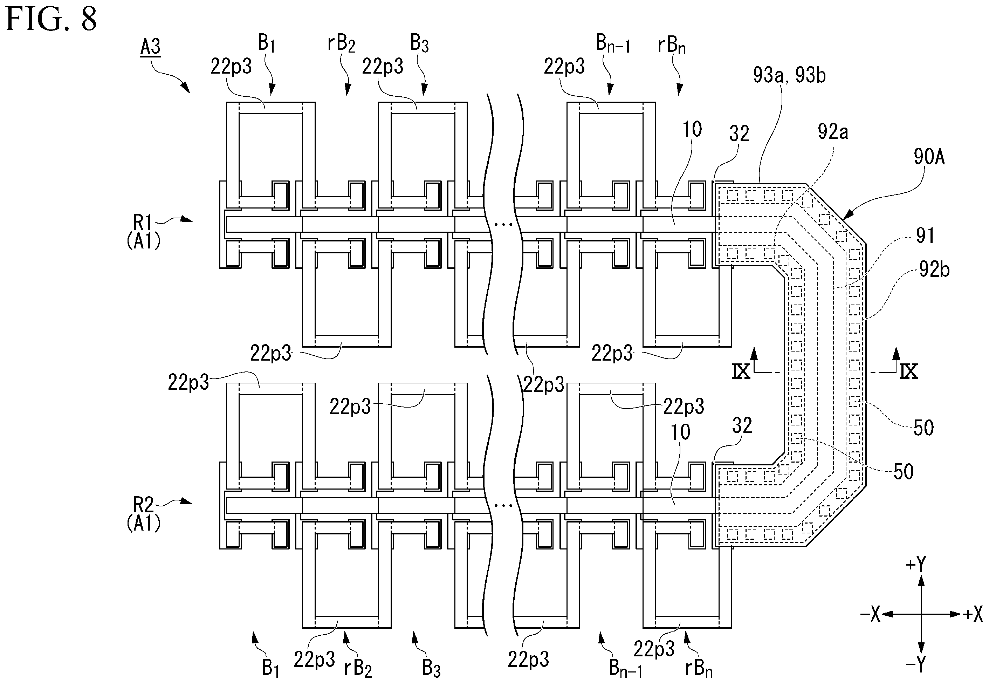

The signal line connection path 91 is an elongated plate-shaped conductor having a constant width, a constant thickness, and a predetermined length. The signal line connection path 91 connects the signal line 10 included in the first row R1 and the signal line 10 included in the second row R2. In the example shown in FIG. 7, the signal line connection path 91 has a shape consisting of three linear portions, but the shape of the signal line connection path 91 is not limited to this. For example, the signal line connection path 91 may include four or more linear portions (see also FIG. 8) or may include a curved portion.

A first ground line connection path 92a of the pair of ground line connection paths 92a and 92b is an elongated plate-shaped conductor having a constant width, a constant thickness, and a predetermined length. The first ground line connection path 92a extends parallel to the signal line connection path 91, and is located inside the signal line connection path 91. The first ground line connection path 92a connects the second line 22 included in the n-th digital phase shift circuit rBₙ of the first row R1 and the second ground conductor 32 included in the n-th digital phase shift circuit rBₙ of the second row R2.

A second ground line connection path 92b of the pair of ground line connection paths 92a and 92b is an elongated plate-shaped conductor having a constant width, a constant thickness, and a predetermined length. The second ground line connection path 92b extends parallel to the signal line connection path 91, and is located outside the signal line connection path 91. The second ground line connection path 92b connects the second ground conductor 32 included in the n-th digital phase shift circuit rBₙ of the first row R1 and the second line 22 included in the n-th digital phase shift circuit rBₙ of the second row R2.

In addition, in the digital phase shifter A2 according to the present embodiment, the first row R1 and the second row R2 are disposed such that the n (plurality of) third parallel lines 22p3 included in the first row R1 and the n (plurality of) third parallel lines 22p3 included in the second row R2 are not adjacent to each other (do not face each other) in the intersection direction Y. For example, the third parallel line 22p3 included in the first digital phase shift circuit B₁ of the second row R2 and the third parallel line 22p3 included in the second digital phase shift circuit rB₂ of the first row R1 deviate from each other in the longitudinal direction X. In addition, the third parallel line 22p3 included in the second digital phase shift circuit rB₂ of the first row R1 and the third parallel line 22p3 included in the third digital phase shift circuit B₃ of the second row R2 deviate from each other in the longitudinal direction X.

As described above, by disposing the first row R1 and the second row R2, the third parallel line 22p3 included in the first row R1 and the third parallel line 22p3 included in the second row R2 can be disposed apart from each other. In other words, the return paths (loop lines through which the third return current flows) in the high-latency mode can be disposed apart from each other between the first row R1 and the second row R2. Therefore, the value of the inductance of the return path (the inductance of the transmission system) can be further increased in the high-latency mode.

As described above, the digital phase shifter A2 according to the present embodiment includes the first row R1 including the plurality of basic digital phase shift circuits B and the plurality of inverted digital phase shift circuits rB, the second row R2 including the plurality of basic digital phase shift circuits B and the plurality of inverted digital phase shift circuits rB and extending parallel to the first row R1 to overlap the first row R1 in the intersection direction Y, and the connection portion 90 that electrically connects the first end portion (+X side) of the first row R1 and the first end portion (+X side) of the second row R2, in which the plurality of basic digital phase shift circuits B and the plurality of inverted digital phase shift circuits rB included in the first row R1 are alternately cascade-connected in the longitudinal direction X, the plurality of digital phase shift circuits B and the plurality of inverted digital phase shift circuits rB included in the second row R2 are alternately cascade-connected in the longitudinal direction X, and the plurality of third parallel lines 22p3 included in the first row R1 and the plurality of third parallel lines 22p3 included in the second row R2 are not adjacent to each other in the intersection direction Y. With this configuration, the value of the inductance of the return path (the inductance of the transmission system) can be further increased in the high-latency mode, and the difference (phase shift amount) between the phase θ_{L} in the low-latency mode and the phase θ_{H} in the high-latency mode can be further increased.

In addition, in the first row R1 and the second row R2, the digital phase shift circuit B and the inverted digital phase shift circuit rB that are adjacent to each other in the longitudinal direction X are cascade-connected to each other such that the digital phase shift circuit B and the inverted digital phase shift circuit rB partially enter each other. With this configuration, it is possible to achieve the size reduction in the digital phase shifter A2.

In addition, the connection portion 90 includes the signal line connection path 91 that connects the signal line 10 included in the first row R1 and the signal line 10 included in the second row R2, and the pair of ground line connection paths 92a and 92b disposed with a spacing on both sides of the signal line connection path 91.

### (Sixth Embodiment)

Next, a sixth embodiment will be described. As shown in FIG. 8, a digital phase shifter A3 according to the sixth embodiment has a structure in which the connection portion 90 is replaced with a connection portion 90A in the digital phase shifter A2 according to the fifth embodiment. Therefore, the configurations other than the connection portion 90A in the digital phase shifter A3 according to the sixth embodiment are denoted by the same reference signs as the configurations of the digital phase shifter A2 according to the fifth embodiment, and the detailed description thereof will be omitted.

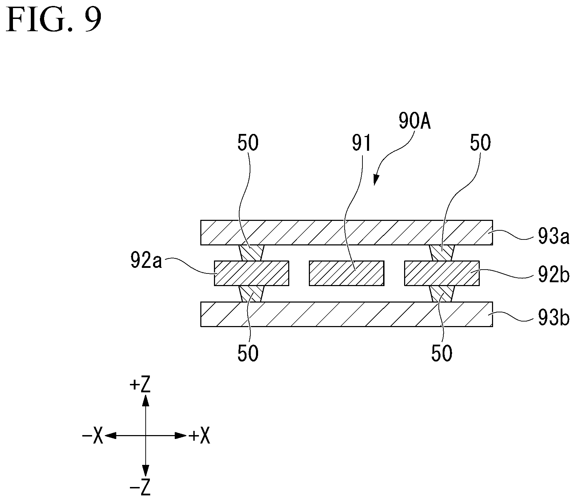

As shown in FIG. 9, the connection portion 90A according to the present embodiment includes the signal line connection path 91, the pair of ground line connection paths 92a and 92b, a pair of ground layers 93a and 93b, and the plurality of connection conductors 50. That is, the connection portion 90A according to the present embodiment has a configuration in which the pair of ground layers 93a and 93b and the plurality of connection conductors 50 are added to the connection portion 90 according to the fifth embodiment.

In the pair of ground layers 93a and 93b, a first ground layer 93a is disposed above the signal line connection path 91 and the pair of ground line connection paths 92a and 92b at a predetermined distance as shown in FIG. 9. The first ground layer 93a is connected to the pair of ground line connection paths 92a and 92b through the plurality of connection conductors 50. As shown in FIG. 8, the plurality of connection conductors 50 are arranged along the first ground line connection path 92a, and are arranged along the second ground line connection path 92b.

In the pair of ground layers 93a and 93b, the second ground layer 93b is disposed below the signal line connection path 91 and the pair of ground line connection paths 92a and 92b at a predetermined distance as shown in FIG. 9. The second ground layer 93b is connected to the pair of ground line connection paths 92a and 92b through the plurality of connection conductors 50. Similarly to the above-described configuration, the plurality of connection conductors 50 are arranged along the first ground line connection path 92a, and are arranged along the second ground line connection path 92b.

By adopting the connection portion 90A as described above, it is possible to form a tri-plate line structure in which the signal line connection path 91 is interposed between the ground layers 93a and 93b. As a result, it is possible to reduce the influence of the electromagnetic field of the connection portion 90A on the outside.

As described above, in the digital phase shifter A3 according to the present embodiment, the connection portion 90A further includes the ground layers 93a and 93b disposed on the upper side and the lower side of the signal line connection path 91 and the pair of ground line connection paths 92a and 92b, and the connection conductor 50 that connects the pair of ground line connection paths 92a and 92b to the ground layers 93a and 93b. With this configuration, it is possible to reduce the influence of the electromagnetic field of the connection portion 90A on the outside.

In the above description, the connection portion 90A includes the pair of ground layers 93a and 93b, but the connection portion 90A may have only one of the pair of ground layers 93a and 93b. That is, the ground layer 93a (93b) need only be disposed on at least one of the upper side or the lower side of the signal line connection path 91 and the pair of ground line connection paths 92a and 92b.

### (Seventh Embodiment)

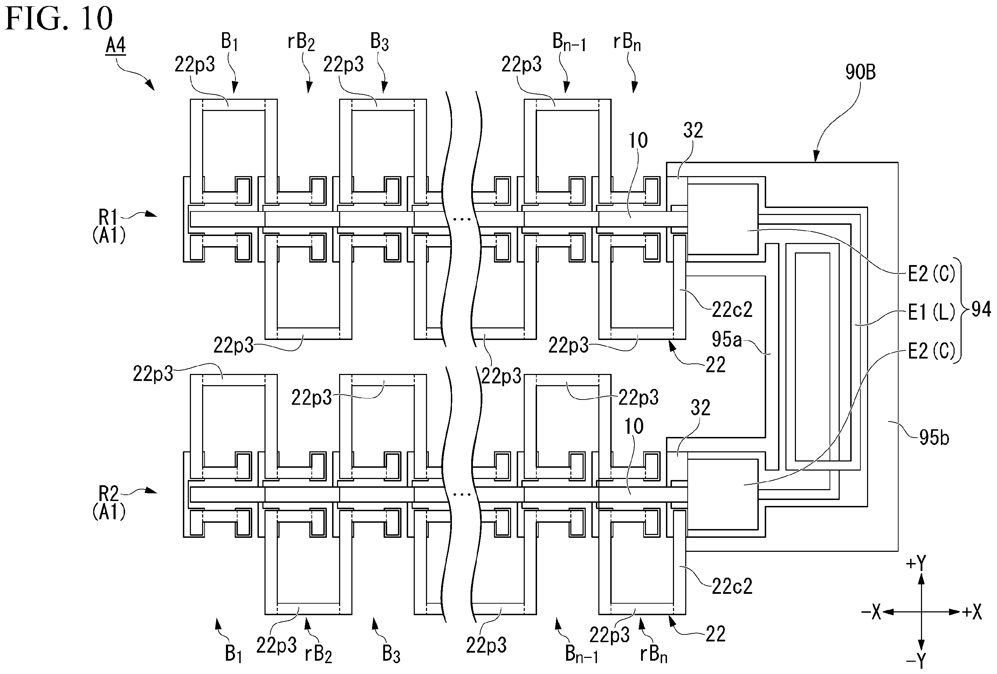

Next, a seventh embodiment will be described. As shown in FIG. 10, a digital phase shifter A4 according to the seventh embodiment has a structure in which the connection portion 90 is replaced with a connection portion 90B in the digital phase shifter A2 according to the fifth embodiment. Therefore, the configurations other than the connection portion 90B in the digital phase shifter A4 according to the seventh embodiment are denoted by the same reference signs as the configurations of the digital phase shifter A2 according to the fifth embodiment, and the detailed description thereof will be omitted.

As shown in FIG. 10, the connection portion 90B according to the present embodiment includes a connection circuit 94 and a pair of ground portions 95a and 95b disposed with a spacing on both sides of the connection circuit 94. However, the connection portion 90B need not include the pair of ground portions 95a and 95b.

A first ground portion 95a of the pair of ground portions 95a and 95b is located inside the connection circuit 94. The first ground portion 95a is electrically grounded. In the example of FIG. 10, the first ground portion 95a is a flat plate-shaped conductor that connects the second line 22 (second intersecting line 22c2) included in the n-th digital phase shift circuit rBₙ of the first row R1 and the second ground conductor 32 included in the n-th digital phase shift circuit rBₙ of the second row R2.

A second ground portion 95b of the pair of ground portions 95a and 95b is located outside the connection circuit 94. The second ground portion 95b is electrically grounded. In the example of FIG. 10, the second ground portion 95b is a flat plate-shaped conductor that connects the second ground conductor 32 included in the n-th digital phase shift circuit rBₙ of the first row R1 and the second line 22 (second intersecting line 22c2) included in the n-th digital phase shift circuit rBₙ of the second row R2.

The shapes of the pair of ground portions 95a and 95b are not limited to the examples of FIG. 10. Each of the pair of ground portions 95a and 95b may be, for example, an elongated plate-shaped conductor having a constant width, a constant thickness, and a predetermined length. In addition, the first ground portion 95a may connect the second ground conductor 32 included in the n-th digital phase shift circuit rBₙ of the first row R1 and the second ground conductor 32 included in the n-th digital phase shift circuit rBₙ of the second row R2. Similarly, the second ground portion 95b may connect the second ground conductor 32 included in the n-th digital phase shift circuit rBₙ of the first row R1 and the second ground conductor 32 included in the n-th digital phase shift circuit rBₙ of the second row R2.

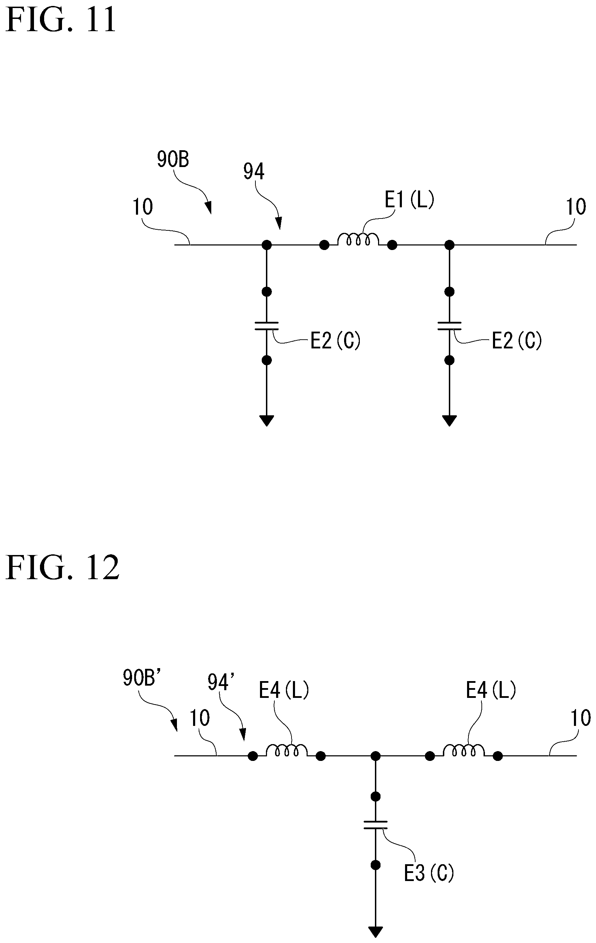

The connection circuit 94 connects the signal line 10 included in the first row R1 and the signal line 10 included in the second row R2. The connection circuit 94 according to the present embodiment includes a first element E1 and a pair of second elements E2. The connection circuit 94 constitutes a π-type circuit shown in FIG. 11.

The first element E1 is connected in series between the signal line 10 included in the first row R1 (see also FIG. 10) and the signal line 10 included in the second row R2 (see also FIG. 10). The first element E1 in the shown example is a coil L. As the coil L, for example, a spiral inductor can be suitably used. The spiral inductor bridges substantially the entire section of the connection portion 90B. A configuration other than the spiral inductor, such as a winding coil, a laminated coil, or a thin film coil, may be used as the coil L.

The pair of second elements E2 are connected in parallel on both sides of the first element E1. The second element E2 in the shown example is a capacitor C. In the capacitor C, the upper electrode is connected to the end portion of the coil L, and the lower electrode is electrically grounded. As the capacitor C, for example, a thin film capacitor having a metal insulator metal (MIM) structure can be used. The capacitances of a pair of capacitors C are equal to each other. In addition, a comb-tooth type capacitor may be used as the capacitor C instead of the parallel flat plate capacitor.

By using the first element E1 and the pair of second elements E2 described above, the circuit impedance can be accurately controlled, and the distribution of the phase shift amount caused by the weak reflection generated before and after the connection portion 90B can be averaged.

The connection portion 90B may include a ground layer (not shown) disposed a predetermined distance below the connection circuit 94 and the pair of ground portions 95a and 95b. In this case, the ground layer and each of the ground portions 95a and 95b may be connected to each other through, for example, the connection conductor 50.

As described above, in the digital phase shifter A4 according to the present embodiment, the connection portion 90B includes the first element E1 connected in series between the signal line 10 included in the first row R1 and the signal line included in the second row R2, and the pair of second elements E2 connected in parallel on both sides of the first element E1, in which the first element E1 is the coil **L,** and the second element E2 is the capacitor C. With this configuration, the circuit impedance can be strictly controlled, and the distribution of the phase shift amount caused by the weak reflection generated before and after the connection portion 90B can be averaged.

In the above-described example, the first element E1 is the coil L and the second element E2 is the capacitor C, but the first element E1 may be the capacitor C, and the second element E2 may be the coil L. Even with this configuration, the circuit impedance can be strictly controlled, and the distribution of the phase shift amount caused by the weak reflection generated before and after the connection portion 90B can be averaged.

In addition, an electronic switch connected in series to the second element E2 may be provided between the pair of second elements E2 and the ground. This electronic switch switches whether or not to electrically ground each second element E2. With this configuration, the phase shift amount can be adjusted in the connection portion 90B. As the electronic switch, for example, a MOS type FET, a bipolar transistor (BJT), and the like can be used.

The electronic switch may be provided only in one of the pair of second elements E2.

In addition, as a modification example of the seventh embodiment, a connection portion 90B' having a connection circuit 94' constituting a T-type circuit as shown in FIG. 12 may be adopted instead of the connection portion 90B including the connection circuit 94 constituting the π-type circuit. The connection circuit 94' includes a third element E3 and a pair of fourth elements E4.

The third element E3 is connected in parallel between the signal line 10 included in the first row R1 (see also FIG. 10) and the signal line 10 included in the second row R2 (see also FIG. 10). The third element E3 in the shown example is the capacitor C. In the capacitor C, the upper electrode is connected between a pair of fourth elements E4 (details will be described below), and the lower electrode is electrically grounded.

The pair of fourth elements E4 are connected in series on both sides of the third element E3. In addition, the pair of fourth elements E4 are connected in series between the signal line 10 included in the first row R1 (see also FIG. 10) and the signal line 10 included in the second row R2 (see also FIG. 10). The fourth element E4 in the shown example is the coil L. The inductances of the pair of coils L are equal to each other.

As described above, the connection portion 90B' according to the modification example of the present embodiment includes the third element E3 connected in parallel between the signal line 10 included in the first row R1 and the signal line 10 included in the second row R2, and the pair of fourth elements E4 connected in series on both sides of the third element E3, in which the third element E3 is the capacitor C, and the fourth element E4 is the coil L. Even with this configuration, the circuit impedance can be strictly controlled, and the distribution of the phase shift amount caused by the weak reflection generated before and after the connection portion 90B' can be averaged.

In the above-described example, the third element E3 is the capacitor C, and the fourth element E4 is the coil L, but the third element E3 may be the coil L, and the fourth element E4 may be the capacitor C. Even with this configuration, the circuit impedance can be strictly controlled, and the distribution of the phase shift amount caused by the weak reflection generated before and after the connection portion 90B' can be averaged.

In addition, an electronic switch connected in series to the third element E3 may be provided between the third element E3 and the ground. This electronic switch switches whether or not to electrically ground the third element E3. With this configuration, the phase shift amount can be adjusted in the connection portion 90B'. As the electronic switch, for example, a MOS type FET, a bipolar transistor (BJT), and the like can be used.

The technical scope of the present invention is not limited to the embodiments described above, and various modifications can be made without departing from the gist of the present invention. In addition, the components in the embodiments described above can be replaced with well-known components as appropriate, and the embodiments described above may be combined with each other as appropriate without departing from the gist of the present invention.

For example, a digital phase shifter A1' in which basic digital phase shift circuits B' identical to the digital phase shift circuit B' according to the second embodiment and inverted digital phase shift circuits rB' in which the basic digital phase shift circuits B' are inverted are alternately cascade-connected may be adopted by combining the second embodiment and the fourth embodiment. In addition, digital phase shifters A2', A3', and A4' to which the digital phase shifter A1' is applied in the first row R1 and the second row R2 may be adopted.

### REFERENCE SIGNS LIST

A1, A2, A3, A4 Digital phase shifter
B, B', B" Digital phase shift circuit
rB Inverted digital phase shift circuit
10 Signal line
21 First line
21p1 First parallel line
21c1 Fourth intersecting line
21p2 Fifth parallel line
21c2 Fifth intersecting line
22 Second line
22p2 Second parallel line
22c1 First intersecting line
22p3 Third parallel line
22c2 Second intersecting line
22p4 Fourth parallel line
22c3 Third intersecting line
31 First ground conductor
32 Second ground conductor
41 First electronic switch
42 Second electronic switch
50 Connection conductor
90, 90A, 90B, 90B' Connection portion
91 Signal line connection path
92a First ground line connection path
92b Second ground line connection path
93a First ground layer
93b Second ground layer
P4 Fourth connection pad (connection pad)
R1 First row
R2 Second row
E1 First element
E2 Second element
E3 Third element
E4 Fourth element

## Claims

1. A digital phase shift circuit comprising:
a signal line;
a first line including a first parallel line extending parallel to the signal line;
a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, and a second intersecting line extending toward the signal line in the intersection direction from a first end portion of the third parallel line;
a first ground conductor electrically connected to a first end portion of the first parallel line and the first end portion of the second parallel line;
a second ground conductor connected to a first end portion of the second line;
a first electronic switch provided between a second end portion of the first parallel line and the second ground conductor; and
a second electronic switch provided between a second end portion of the second parallel line and the second ground conductor,
wherein the signal line is located between the first parallel line and the second parallel line.

2. The digital phase shift circuit according to Claim 1, further comprising:
a connection pad provided between the second end portion of the second parallel line and the second electronic switch,
wherein a maximum value of a dimension of the connection pad in the intersection direction is greater than a width of the second parallel line.

3. The digital phase shift circuit according to Claim 2,
wherein at least a part of the second intersecting line and at least a part of the connection pad face each other in the longitudinal direction.

4. The digital phase shift circuit according to any one of Claims 1 to 3,
wherein, in the intersection direction, a distance between a center line of the second parallel line and a center line of the third parallel line is greater than a distance between the center line of the second parallel line and an outer edge of the first ground conductor on a side of the third parallel line.

5. The digital phase shift circuit according to any one of Claims 1 to 4,
wherein at least one of the first ground conductor or the second ground conductor has a multilayer structure.

6. The digital phase shift circuit according to any one of Claims 1 to 5,
wherein the second intersecting line extends to intersect the second parallel line, the signal line, and the first parallel line in a plan view, and
the second line further includes a fourth parallel line extending parallel to the signal line from a first end portion of the second intersecting line, and a third intersecting line extending toward the signal line in the intersection direction from a first end portion of the fourth parallel line.

7. The digital phase shift circuit according to any one of Claims 1 to 6,
wherein the first line further includes a fourth intersecting line extending away from the signal line in the intersection direction from the first end portion of the first parallel line, a fifth parallel line extending parallel to the signal line from a first end portion of the fourth intersecting line, and a fifth intersecting line extending toward the signal line in the intersection direction from a first end portion of the fifth parallel line.

8. A digital phase shifter comprising:
a plurality of the digital phase shift circuits according to any one of Claims 1 to 6; and
a plurality of inverted digital phase shift circuits in which the digital phase shift circuits are inverted with respect to a center line of the signal line,
wherein the plurality of digital phase shift circuits and the plurality of inverted digital phase shift circuits are alternately cascade-connected in the longitudinal direction.

9. The digital phase shifter according to Claim 8,
wherein the digital phase shift circuit and the inverted digital phase shift circuit that are adjacent to each other in the longitudinal direction are cascade-connected such that the digital phase shift circuit and the inverted digital phase shift circuit partially enter each other.

10. A digital phase shifter comprising:
a first row including a plurality of the digital phase shift circuits according to any one of Claims 1 to 6 and a plurality of inverted digital phase shift circuits in which the digital phase shift circuits are inverted with respect to a center line of the signal line;
a second row including a plurality of the digital phase shift circuits according to any one of Claims 1 to 6 and a plurality of inverted digital phase shift circuits in which the digital phase shift circuits are inverted with respect to a center line of the signal line, and extending parallel to the first row to overlap the first row when viewed in the intersection direction; and
a connection portion configured to electrically connect a first end portion of the first row and a first end portion of the second row,
wherein the plurality of digital phase shift circuits and the plurality of inverted digital phase shift circuits included in the first row are alternately cascade-connected in the longitudinal direction,
the plurality of digital phase shift circuits and the plurality of inverted digital phase shift circuits included in the second row are alternately cascade-connected in the longitudinal direction, and
the third parallel line included in the first row and the third parallel line included in the second row are not adjacent to each other in the intersection direction.

11. The digital phase shifter according to Claim 10,
wherein the digital phase shift circuit and the inverted digital phase shift circuit that are adjacent to each other in the longitudinal direction in the first row are cascade-connected such that the digital phase shift circuit and the inverted digital phase shift circuit partially enter each other, and
the digital phase shift circuit and the inverted digital phase shift circuit that are adjacent to each other in the longitudinal direction in the second row are cascade-connected such that the digital phase shift circuit and the inverted digital phase shift circuit partially enter each other.

12. The digital phase shifter according to Claim 10 or 11,
wherein the connection portion includes a signal line connection path configured to connect the signal line included in the first row and the signal line included in the second row, and a pair of ground line connection paths disposed with a spacing on both sides of the signal line connection path.

13. The digital phase shifter according to Claim 12,
wherein the connection portion further includes a ground layer disposed on at least one of an upper side or a lower side of the signal line connection path and the pair of ground line connection paths, and a connection conductor configured to connect the pair of ground line connection paths and the ground layer.

14. The digital phase shifter according to Claim 10 or 11,
wherein the connection portion includes a first element connected in series between the signal line included in the first row and the signal line included in the second row, and a pair of second elements connected in parallel on both sides of the first element, and
of the first element and the second elements, one element is a coil, and the other element is a capacitor.

15. The digital phase shifter according to Claim 10 or 11,
wherein the connection portion includes a third element connected in parallel between the signal line included in the first row and the signal line included in the second row, and a pair of fourth elements connected in series on both sides of the third element, and
of the third element and the fourth elements, one element is a coil, and the other element is a capacitor.
